# EUROPEAN PATENT APPLICATION

(11) **EP 4 391 773 A1**
(43) Date of publication of application: **26.06.2024**
(21) Application number: 23219275.7
(22) Date of filing: 21.12.2023
(51) Int. Cl.: H10K 59/122, H10K 59/80

(54) **DISPLAY PANEL AND MANUFACTURING METHOD FOR THE SAME**

(30) Priority: 22.12.2022 KR 20220181719
(71) Applicant: Samsung Display Co., Ltd., Gyeonggi-Do (KR)
(72) Inventor: BAE, Subin, Yongin-si (KR); JUNG, Dawoon, Yongin-si (KR); JEONG, Yu-Gwang, Yongin-si (KR); KANG, Taewook, Yongin-si (KR); KIM, Sanggab, Yongin-si (KR)
(74) Representative: Marks & Clerk LLP

(57) **Abstract**

A display panel which includes a base layer, a pixel defining layer defining a first light-emitting opening and a second light-emitting opening therein, a barrier wall including a first barrier wall portion that defines a first barrier opening that overlaps the first light-emitting opening and a second barrier wall portion that defines a second barrier opening that overlaps the second light-emitting opening, a first light-emitting element that is disposed in the first barrier opening and that includes a first anode, a first emission pattern, and a first cathode that contacts the first barrier wall portion, and a second light-emitting element that is disposed in the second barrier opening and that includes a second anode, a second emission pattern, and a second cathode that contacts the second barrier wall portion. A recess is defined in the barrier wall between the first barrier wall portion and the second barrier wall portion.

## Description

### BACKGROUND

### 1. Field

Embodiments of the disclosure described herein relate to a display panel and a display panel manufacturing method, and more particularly, relate to a display panel having improved display quality.

### 2. Description of the Related Art

A display device, such as a television, a monitor, a smart phone, a tablet computer, or the like, which provides an image to a user includes a display panel that displays an image. Various display panels, such as a liquid crystal display panel, an organic light-emitting display panel, an electrowetting display panel, and an electrophoretic display panel, are being developed.

The organic light-emitting display panel may include anodes, cathodes, and emission patterns. The emission patterns may be separated from each other for respective emissive regions, and the cathodes may provide a common voltage for the respective emissive regions.

### SUMMARY

In an embodiment of the disclosure, a display panel includes a base layer, a pixel defining layer that is disposed on the base layer and that includes a first light-emitting opening and a second light-emitting opening spaced apart from the first light-emitting opening in a first direction, a barrier wall that is disposed on the pixel defining layer and that includes a first barrier wall portion that defines a first barrier opening that overlaps the first light-emitting opening and a second barrier wall portion that defines a second barrier opening that overlaps the second light-emitting opening, a first light-emitting element that is disposed in the first barrier opening and that includes a first anode, a first emission pattern, and a first cathode that contacts the first barrier wall portion, and a second light-emitting element that is disposed in the second barrier opening and that includes a second anode, a second emission pattern, and a second cathode that contacts the second barrier wall portion. A recess is defined in the barrier wall between the first barrier wall portion and the second barrier wall portion.

In an embodiment, the display panel may further include a lower encapsulation layer that covers the first light-emitting element and the second light-emitting element. The lower encapsulation layer may include a first lower inorganic encapsulation pattern that overlaps the first light-emitting opening and that is disposed on the first light-emitting element and the first barrier wall portion and a second lower inorganic encapsulation pattern that overlaps the second light-emitting opening and that is disposed on the second light-emitting element and the second barrier wall portion.

In an embodiment, a portion of the first lower inorganic encapsulation pattern and a portion of the second lower inorganic encapsulation pattern may be accommodated in the recess.

In an embodiment, a space may be defined between a portion of the first lower inorganic encapsulation pattern and the pixel defining layer in the recess, and a portion of the second lower inorganic encapsulation pattern may be disposed in the space.

In an embodiment, in the recess, a portion of the first lower inorganic encapsulation pattern and a portion of the second lower inorganic encapsulation pattern may contact each other, and another portion of the first lower inorganic encapsulation pattern and another portion of the second lower inorganic encapsulation pattern may be spaced apart from each other in the first direction.

In an embodiment, a groove may be defined in a thickness direction of the barrier wall in a region of the lower encapsulation layer that overlaps the recess.

In an embodiment, a portion of a side surface that defines the groove may be defined by the first lower inorganic encapsulation pattern, and another portion of the side surface may be defined by the second lower inorganic encapsulation pattern.

In an embodiment, an upper surface of the lower encapsulation layer that overlaps the recess may be flat.

In an embodiment, an upper surface of the first lower inorganic encapsulation pattern and an upper surface of the second lower inorganic encapsulation pattern may be aligned with each other in a region that overlaps the recess.

In an embodiment, a portion of the second emission pattern and a portion of the second cathode may be disposed in the recess.

In an embodiment, the recess, when viewed from above a plane, may have a bar shape that extends in the first direction or a second direction crossing the first direction.

In an embodiment, the recess may have a circular shape when viewed from above a plane.

In an embodiment, the recess may include a plurality of recesses arranged in the first direction or a second direction crossing the first direction.

In an embodiment, the recess may include a plurality of recesses arranged around the first barrier opening and the second barrier opening when viewed from above a plane.

In an embodiment of the disclosure, a method for manufacturing a display panel includes providing a preliminary display panel including a base layer, a first anode disposed on the base layer, a second anode disposed on the base layer, a preliminary pixel defining layer that is disposed on the base layer and that covers the first anode and the second anode, and a preliminary barrier wall, forming a barrier wall by etching the preliminary barrier wall, the barrier wall including a first barrier opening that overlaps the first anode, a second barrier opening that overlaps the second anode, and a recess defined between the first barrier opening and the second barrier opening, forming a pixel defining layer by etching the preliminary pixel defining layer, the pixel defining layer including a first light-emitting opening that exposes a portion of the first anode and a second light-emitting opening that exposes a portion of the second anode, forming a first emission pattern and a first cathode in the first light-emitting opening, forming a first lower inorganic encapsulation pattern that covers the first barrier opening and that is at least partially accommodated in the recess, forming a second emission pattern and a second cathode in the second light-emitting opening, and forming a second lower inorganic encapsulation pattern that covers the second barrier opening and that is at least partially accommodated in the recess.

In an embodiment, the forming the barrier wall including the first barrier opening, the second barrier opening, and the recess may include forming the recess between a first barrier wall portion that defines the first barrier opening and a second barrier wall portion that defines the second barrier opening when the recess is viewed from above a plane, and the first barrier opening, the second barrier opening, and the recess may be simultaneously formed by the same process.

In an embodiment, the forming the first emission pattern and the first cathode in the first light-emitting opening may include forming a first preliminary emission pattern on the pixel defining layer, forming a first preliminary cathode on the first preliminary emission pattern, forming a first photoresist layer on the first preliminary cathode such that the first photoresist layer corresponds to the first light-emitting opening, and forming the first emission pattern and the first cathode by etching the first preliminary emission pattern and the first preliminary cathode, and an edge of the first photoresist layer may overlap the recess.

In an embodiment, the forming the second lower inorganic encapsulation pattern may include forming a groove in a thickness direction of the barrier wall in regions of the first lower inorganic encapsulation pattern and the second lower inorganic encapsulation pattern that overlap the recess. A portion of a side surface that defines the groove may be defined by the first lower inorganic encapsulation pattern, and another portion of the side surface may be defined by the second lower inorganic encapsulation pattern.

In an embodiment, the forming the first emission pattern and the first cathode in the first light-emitting opening may include forming a first preliminary emission pattern on the pixel defining layer, forming a first preliminary cathode on the first preliminary emission pattern, forming a first photoresist layer on the first preliminary cathode such that the first photoresist layer corresponds to the first light-emitting opening, and forming the first emission pattern and the first cathode by etching the first preliminary emission pattern and the first preliminary cathode, and an edge of the first photoresist layer may not overlap the recess.

In an embodiment, the forming the second lower inorganic encapsulation pattern may include etching the second lower inorganic encapsulation pattern such that an upper surface of the first lower inorganic encapsulation pattern and an upper surface of the second lower inorganic encapsulation pattern are aligned with each other in a region that overlaps the recess.

In an embodiment, the method may further include forming an organic encapsulation film on the first lower inorganic encapsulation pattern and the second lower inorganic encapsulation pattern and forming an upper inorganic encapsulation film on the organic encapsulation film.

In an embodiment, the forming the second lower inorganic encapsulation pattern may include forming a space between a portion of the first lower inorganic encapsulation pattern and the pixel defining layer in the recess and filling the space with a portion of the second lower inorganic encapsulation pattern.

In an embodiment of the disclosure, a display panel includes a base layer, a pixel defining layer that is disposed on the base layer and defines a first light-emitting opening and a second light-emitting opening therein, a barrier wall that is disposed on the pixel defining layer and that includes a first barrier wall portion that defines a first barrier opening that overlaps the first light-emitting opening and a second barrier wall portion that defines a second barrier opening that overlaps the second light-emitting opening, a recess being defined between the first barrier wall portion and the second barrier wall portion, a first light-emitting element disposed in the first barrier opening, a second light-emitting element disposed in the second barrier opening, and a lower encapsulation layer including a first lower inorganic encapsulation pattern that covers the first light-emitting element and that is at least partially accommodated in the recess and a second lower inorganic encapsulation pattern that covers the second light-emitting element and that is at least partially accommodated in the recess.

In an embodiment, a groove may be defined in a thickness direction of the barrier wall in a region of the lower encapsulation layer that overlaps the recess, a portion of a side surface that defines the groove may be defined by the first lower inorganic encapsulation pattern, and another portion of the side surface may be defined by the second lower inorganic encapsulation pattern.

In an embodiment, an upper surface of the first lower inorganic encapsulation pattern and an upper surface of the second lower inorganic encapsulation pattern may be aligned with each other in a region that overlaps the recess.

In an embodiment, the second light-emitting element may include a second emission pattern and a second cathode that contacts the second barrier wall portion, and a portion of the second emission pattern and a portion of the second cathode may be disposed in the recess.

At least some of the above and other features of the invention are set out in the claims.

### BRIEF DESCRIPTION OF THE DRAWINGS

The above and other embodiments, advantages and features of the disclosure will become apparent by describing in detail embodiments thereof with reference to the accompanying drawings.
FIG. 1A is a perspective view of an embodiment of a display device according to the disclosure.
FIG. 1B is an exploded perspective view of an embodiment of the display device according to the disclosure.
FIG. 2 is a cross-sectional view of an embodiment of a display module according to the disclosure.
FIG. 3 is a plan view of an embodiment of a display panel according to the disclosure.
FIG. 4 is an equivalent circuit diagram of an embodiment of a pixel according to the disclosure.
FIG. 5 is an enlarged plan view of an embodiment of a portion of a display region according to the disclosure.
FIGS. 6 and 7 are cross-sectional views of the display panel taken along line I-I' of FIG. 5.
FIGS. 8A to 8G are cross-sectional views illustrating an embodiment of some of operations of a display panel manufacturing method according to the disclosure.
FIGS. 9A to 9C are cross-sectional views illustrating an embodiment of some of the operations of the display panel manufacturing method according to the disclosure.
FIGS. 10A to 10D are cross-sectional views illustrating an embodiment of some of the operations of the display panel manufacturing method according to the disclosure.
FIGS. 11A and 11B are cross-sectional views illustrating an embodiment of some of the operations of the display panel manufacturing method according to the disclosure.
FIGS. 12A to 12D are cross-sectional views illustrating an embodiment of some of the operations of the display panel manufacturing method according to the disclosure.
FIG. 13 is an enlarged plan view of an embodiment of a portion of a display region according to the disclosure.
FIG. 14 is an enlarged plan view of an embodiment of a portion of a display region according to the disclosure.

### DETAILED DESCRIPTION

In this specification, when it is mentioned that a component (or, a region, a layer, a part, etc.) is referred to as being "on", "connected to" or "coupled to" another component, this means that the component may be directly on, connected to, or coupled to the other component or a third component may be therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms used herein, including technical or scientific terms, have the same meanings as those generally understood by those skilled in the art to which the disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the application.

Hereinafter, embodiments of the disclosure will be described with reference to the accompanying drawings.

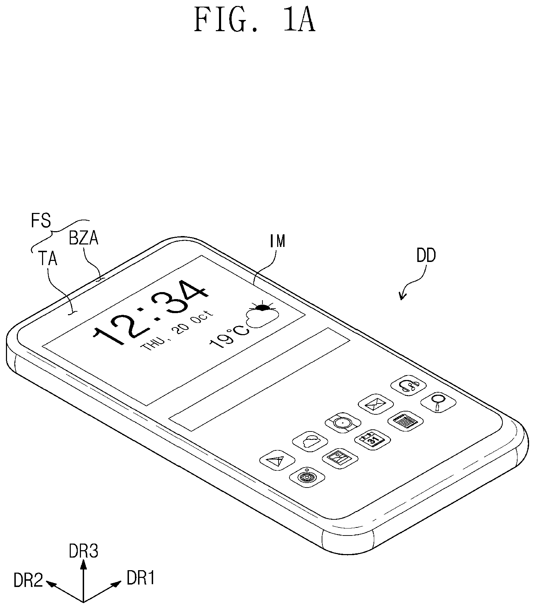

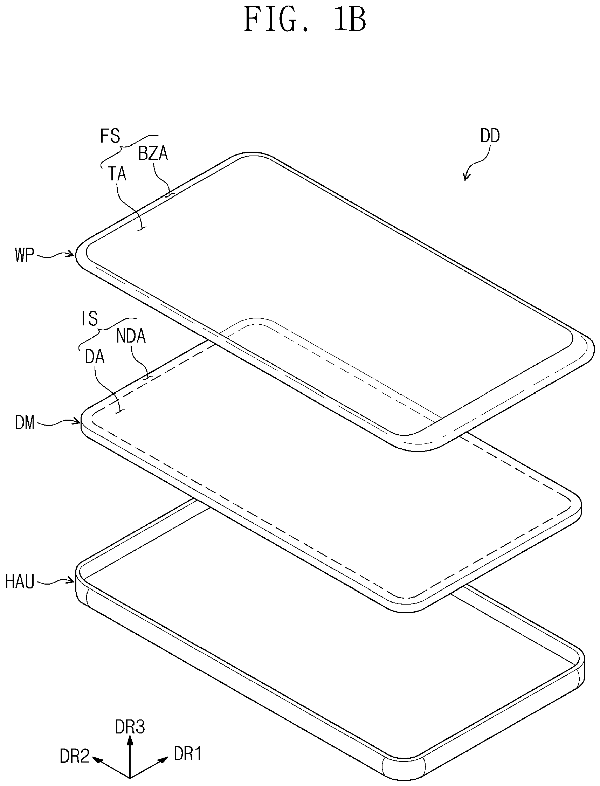

FIG. 1A is a perspective view of an embodiment of a display device DD according to the disclosure. FIG. 1B is an exploded perspective view of an embodiment of the display device DD according to the disclosure.

In an embodiment, the display device DD may be a relatively large electronic device such as a television, a monitor, or a billboard. In addition, the display device DD may be a relatively small and medium-sized electronic device such as a personal computer, a notebook computer, a personal digital terminal, a car navigation unit, a game machine, a smart phone, a tablet computer, or a camera. However, this is illustrative, and the display device DD may be employed as other display devices without departing from the scope of the disclosure. In FIGS. 1A and 1B, the display device DD is illustrated as a smart phone.

Referring to FIGS. 1A and 1B, the display device DD may display an image IM in a third direction DR3 on a display surface FS that is parallel to a first direction DR1 and a second direction DR2. The image IM may include a still image as well as a dynamic image. In FIG. 1A, a clock window and icons are illustrated as embodiments of the image IM. The display surface FS on which the image IM is displayed may correspond to a front surface of the display device DD.

In this embodiment, front surfaces (or, upper surfaces) and rear surfaces (or, lower surfaces) of members are defined based on the direction in which the image IM is displayed. The front surfaces and the rear surfaces may face away from each other in the third direction DR3, and normal directions of the front surfaces and the rear surfaces may be parallel to the third direction DR3. The directions indicated by the first to third directions DR1, DR2, and DR3 may be relative concepts and may be changed to different directions. As used herein, the expression "in a plan view" may mean that it is viewed in the third direction DR3.

The display device DD may include a window WP, a display module DM, and a housing HAU. The window WP and the housing HAU may be coupled with each other to form an exterior of the display device DD.

The window WP may include an optically clear insulating material. In an embodiment, the window WP may include glass or plastic, for example. A front surface of the window WP defines the display surface FS of the display device DD. The display surface FS may include a transmissive region TA and a bezel region BZA. The transmissive region TA may be an optically clear region. In an embodiment, the transmissive region TA may be a region having a visible light transmittance of about 90% or more, for example.

The bezel region BZA may be a region having a lower light transmittance than the transmissive region TA. The bezel region BZA may define the shape of the transmissive region TA. The bezel region BZA may be adjacent to the transmissive region TA and may surround the transmissive region TA. However, this is illustrative, and the bezel region BZA of the window WP may be omitted. The window WP may include at least one of an anti-fingerprint layer, a hard coating layer, and an anti-reflection layer, but is not limited to any particular embodiment.

The display module DM may be disposed under the window WP. The display module DM may be a component that substantially generates the image IM. The image IM generated by the display module DM may be displayed on a display surface IS of the display module DM and may be visually recognized by a user from the outside through the transmissive region TA.

The display module DM may include a display region DA and a non-display region NDA. The display region DA may be a region activated in response to an electrical signal. The non-display region NDA may be adjacent to the display region DA. The non-display region NDA may surround the display region DA. The non-display region NDA may be a region covered by the bezel region BZA and may not be visible from the outside.

The housing HAU may be coupled with the window WP. The housing HAU may be coupled with the window WP to provide a predetermined inner space. The display module DM may be accommodated in the inner space.

The housing HAU may include a material having a relatively high rigidity. In an embodiment, the housing HAU may include glass, plastic, or metal, or may include a plurality of frames and/or plates including or consisting of a combination of the aforementioned materials, for example. The housing HAU may stably protect components of the display device DD accommodated in the inner space from an external impact.

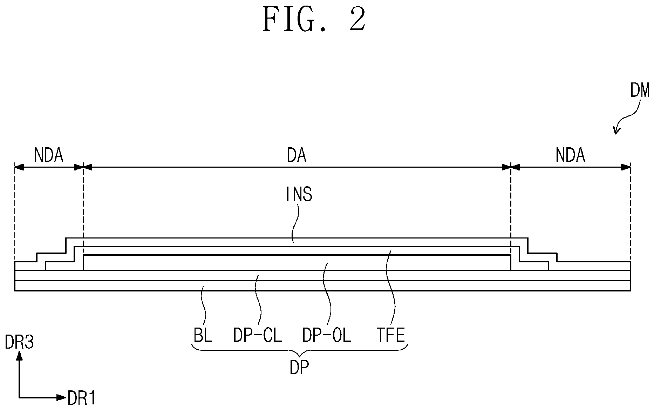

FIG. 2 is a cross-sectional view of an embodiment of the display module DM according to the disclosure.

Referring to FIG. 2, the display module DM may include a display panel DP and an input sensor INS. Although not separately illustrated, the display device DD (refer to FIG. 1A) in an embodiment of the disclosure may further include a protective member disposed on a lower surface of the display panel DP and an anti-reflection member and/or a window member disposed on an upper surface of the input sensor INS.

The display panel DP may be an emissive display panel. However, this is illustrative, and the disclosure is not particularly limited thereto. In an embodiment, the display panel DP may be an organic light-emitting display panel or an inorganic light-emitting display panel. An emissive layer in the organic light-emitting display panel may include an organic light-emitting material, for example. An emissive layer in the inorganic light-emitting display panel may include quantum dots, quantum rods, or micro light emitting diodes ("LEDs"). Hereinafter, it will be exemplified that the display panel DP is an organic light-emitting display panel.

The display panel DP includes a base layer BL, and a circuit element layer DP-CL, a display element layer DP-OL, and a thin film encapsulation layer TFE that are disposed on the base layer BL. The input sensor INS may be directly disposed on the thin film encapsulation layer TFE. As used herein, the expression "component A is directly disposed on component B" may mean that an adhesive layer is not disposed between component A and component B.

The base layer BL may include at least one plastic film. The base layer BL may be a flexible substrate and may include a plastic substrate, a glass substrate, a metal substrate, or an organic/inorganic composite substrate. The display region DA and the non-display region NDA that have been described above with reference to FIG. 1B may be identically defined in the base layer BL.

The circuit element layer DP-CL may include at least one insulating layer and a circuit element. The insulating layer includes at least one inorganic layer and at least one organic layer. The circuit element includes signal lines and a pixel drive circuit.

The display element layer DP-OL may include a barrier wall and a light-emitting element. The light-emitting element may include an anode, an intermediate layer, and a cathode.

The thin film encapsulation layer TFE may include a plurality of thin films. Some of the thin films may be disposed to improve optical efficiency, and the other thin films are disposed to protect organic light-emitting diodes.

The input sensor INS obtains coordinate information of an external input. The input sensor INS may have a multi-layer structure. The input sensor INS may include a single conductive layer or multiple conductive layers. Furthermore, the input sensor INS may include a single insulating layer or multiple insulating layers. The input sensor INS may sense the external input in a capacitive manner. However, this is illustrative, and the disclosure is not limited thereto. In an embodiment, the input sensor INS may sense the external input using an electromagnetic induction method or a pressure sensing method, for example. In an embodiment of the disclosure, the input sensor INS may be omitted.

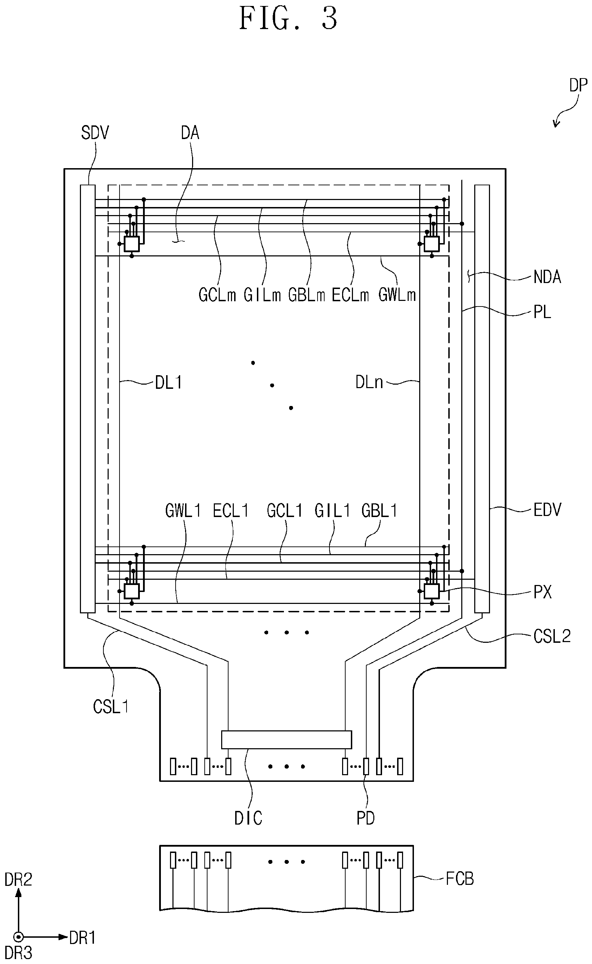

FIG. 3 is a plan view of an embodiment of the display panel DP according to the disclosure.

Referring to FIG. 3, a display region DA and a non-display region NDA around the display region DA may be defined in the display panel DP. The display region DA and the non-display region NDA may be distinguished from each other depending on whether pixels PX are disposed. The pixels PX may be disposed in the display region DA. A scan driver SDV, a data driver, and an emission driver EDV may be disposed in the non-display region NDA. The data driver may be a circuit configured in a driver integrated circuit ("IC") DIC.

The display panel DP may include the pixels PX, initialization scan lines GIL1 to GILm, compensation scan lines GCL1 to GCLm, write scan lines GWL1 to GWLm, black scan lines GBL1 to GBLm, emission control lines ECL1 to ECLm, data lines DL1 to DLn, first and second control lines CSL1 and CSL2, a drive voltage line PL, and a plurality of pads PD. Here, "m" and "n" are natural numbers of 2 or larger.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL 1 to GBLm may extend in the first direction DR1 and may be electrically connected to the scan driver SDV. The data lines DL1 to DLn may extend in the second direction DR2 and may be electrically connected to the driver IC DIC. The emission control lines ECL1 to ECLm may extend in the first direction DR1 and may be electrically connected to the emission driver EDV.

The drive voltage line PL may include a portion extending in the first direction DR1 and a portion extending in the second direction DR2. The portion extending in the first direction DR1 and the portion extending in the second direction DR2 may be disposed in different layers. The drive voltage line PL may provide a drive voltage to the pixels PX.

The first control line CSL1 may be connected to the scan driver SDV. The second control line CSL2 may be connected to the emission driver EDV.

The driver IC DIC, the drive voltage line PL, the first control line CSL1, and the second control line CSL2 may be electrically connected to the pads PD. A flexible circuit film FCB may be electrically connected to the pads PD through an anisotropic conductive adhesive layer. The pads PD may be pads for connecting the flexible circuit film FCB to the display panel DP. The pads PD may be connected to the corresponding pixels PX through the drive voltage line PL, the first control line CSL1, and the second control line CSL2.

In addition, the pads PD may further include input pads. The input pads may be pads for connecting the flexible circuit film FCB to the input sensor INS (refer to FIG. 2). However, without being limited thereto, the input pads may be disposed in the input sensor INS and may be connected with the pads PD and a separate circuit board. In an alternative embodiment, the input sensor INS may be omitted and may not further include the input pads.

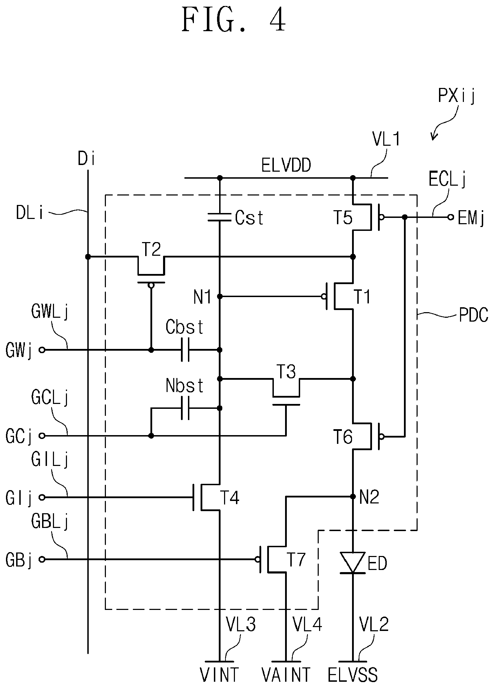

FIG. 4 is an equivalent circuit diagram of an embodiment of a pixel PXij according to the disclosure.

FIG. 4 illustrates the equivalent circuit diagram of the pixel PXij among the plurality of pixels PX (refer to FIG. 3). The plurality of pixels PX have the same circuit structure. Therefore, description of the circuit structure for the pixel PXij may be applied to the remaining pixels PX, and detailed description of the remaining pixels PX will be omitted.

Referring to FIGS. 3 and 4, the pixel PXij is connected to the i-th data line DLi among the data lines DL1 to DLn, the j-th initialization scan line GILj among the initialization scan lines GIL1 to GELm, the j-th compensation scan line GCLj among the compensation scan lines GCL1 to GCLm, the j-th write scan line GWLj among the write scan lines GWL1 to GWLm, the j-th black scan line GBLj among the black scan lines GBL1 to GBLm, the j-th emission control line ECLj among the emission control lines ECL1 to ECLm, first and second drive voltage lines VL1 and VL2, and first and second initialization voltage lines VL3 and VL4. "i" is an integer of 1 to n, and "j" is an integer of 1 to m.

The pixel PXij includes a light-emitting element ED and a pixel circuit PDC. The light-emitting element ED may be a light-emitting diode. In an embodiment of the disclosure, the light-emitting element ED may be an organic light-emitting diode including an organic light-emitting layer, but is not particularly limited thereto. The pixel circuit PDC may control the amount of current flowing through the light-emitting element ED in response to a data signal Di. The light-emitting element ED may emit light having a predetermined luminance in response to the amount of current provided from the pixel circuit PDC.

The pixel circuit PDC may include first to seventh transistors T1, T2, T3, T4, T5, T6, and T7 and first to third capacitors Cst, Cbst, and Nbst. A configuration of the pixel circuit PDC according to the disclosure is not limited to the embodiment illustrated in FIG. 4. The pixel circuit PDC illustrated in FIG. 4 is merely illustrative, and various changes and modifications may be made to the configuration of the pixel circuit PDC.

At least one of the first to seventh transistors T1, T2, T3, T4, T5, T6, and T7 may be a transistor having a low-temperature polycrystalline silicon ("LTPS") semiconductor layer. At least one of the first to seventh transistors T1, T2, T3, T4, T5, T6, and T7 may be a transistor having an oxide semiconductor layer. In an embodiment, the third and fourth transistors T3 and T4 may be oxide semiconductor transistors, and the first, second, fifth, sixth, and seventh transistors T1, T2, T5, T6, and T7 may be LTPS transistors, for example.

Specifically, the first transistor T1 directly affecting the brightness of the light-emitting element ED may include a semiconductor layer including or consisting of polycrystalline silicon having relatively high reliability, and thus the display device having a relatively high resolution may be implemented. An oxide semiconductor has relatively high carrier mobility and relatively low leakage current, and therefore a voltage drop is not great even though operating time is long. That is, the color of an image is not greatly changed depending on a voltage drop even during a low-frequency operation, and therefore the low-frequency operation is possible. Since the oxide semiconductor has an advantage of relatively low leakage current as described above, at least one of the third transistor T3 and the fourth transistor T4, which are connected with a gate electrode of the first transistor T1, may be employed as an oxide semiconductor to reduce power consumption while preventing leakage current that is likely to flow to the gate electrode.

Some of the first to seventh transistors T1, T2, T3, T4, T5, T6, and T7 may be P-type transistors, and the others may be N-type transistors. In an embodiment, the first, second, fifth, sixth, and seventh transistors T1, T2, T5, T6, and T7 may be P-type transistors, and the third and fourth transistors T3 and T4 may be N-type transistors, for example.

A configuration of the pixel circuit PDC according to the disclosure is not limited to the embodiment illustrated in FIG. 4. The pixel circuit PDC illustrated in FIG. 4 is merely illustrative, and various changes and modifications may be made to the configuration of the pixel circuit PDC. In an embodiment, the first to seventh transistors T1, T2, T3, T4, T5, T6, and T7 may all be P-type transistors or N-type transistors, for example. In an alternative embodiment, the first, second, fifth, and sixth transistors T1, T2, T5, and T6 may be P-type transistors, and the third, fourth, and seventh transistors T3, T4, and T7 may be N-type transistors.

The j-th initialization scan line GILj, the j-th compensation scan line GCLj, the j-th write scan line GWLj, the j-th black scan line GBLj, and the j-th emission control line ECLj may transfer the j-th initialization scan signal GIj, the j-th compensation scan signal GCj, the j-th write scan signal GWj, the j-th black scan signal GBj, and the j-th emission control signal EMj to the pixel PXij, respectively. The i-th data line DLi transfers the i-th data signal Di to the pixel PXij. The i-th data signal Di may have a voltage level corresponding to an image signal that is input to the display device DD (refer to FIG. 1).

The first and second drive voltage lines VL1 and VL2 may transfer a first drive voltage ELVDD and a second drive voltage ELVSS to the pixel PXij, respectively. Furthermore, the first and second initialization voltage lines VL3 and VL4 may transfer a first initialization voltage VINT and a second initialization voltage VAINT to the pixel PXij, respectively.

The first transistor T1 is connected between the first drive voltage line VL1 receiving the first drive voltage ELVDD and the light-emitting element ED. The first transistor T1 includes a first electrode connected with the first drive voltage line VL1 via the fifth transistor T5, a second electrode connected with a pixel electrode (or, referred to as an anode) of the light-emitting element ED via the sixth transistor T6, and a third electrode (e.g., a gate electrode) connected with one end of the first capacitor Cst (e.g., a first node N1). The first transistor T1 may receive the i-th data signal Di that the i-th data line DLi transfers depending on a switching operation of the second transistor T2 and may supply a drive current to the light-emitting element ED.

The second transistor T2 is connected between the i-th data line DLi and the first electrode of the first transistor T1. The second transistor T2 includes a first electrode connected with the i-th data line DLi, a second electrode connected with the first electrode of the first transistor T1, and a third electrode (e.g., a gate electrode) connected with the j-th write scan line GWLj. The second transistor T2 may be turned on in response to the j-th write scan signal GWj transferred through the j-th write scan line GWLj and may transfer, to the first electrode of the first transistor T1, the i-th data signal Di transferred from the i-th data line DLi. One end of the second capacitor Cbst may be connected to the third electrode of the second transistor T2, and an opposite end of the second capacitor Cbst may be connected to the first node N1.

The third transistor T3 is connected between the second electrode of the first transistor T1 and the first node N1. The third transistor T3 includes a first electrode connected with the third electrode of the first transistor T1, a second electrode connected with the second electrode of the first transistor T1, and a third electrode (e.g., a gate electrode) connected with the j-th compensation scan line GCLj. The third transistor T3 may be turned on in response to the j-th compensation scan signal GCj transferred through the j-th compensation scan line GCLj and may diode-connect the first transistor T1 by connecting the third electrode of the first transistor T1 and the second electrode of the first transistor T1. One end of the third capacitor Nbst may be connected to the third electrode of the third transistor T3, and an opposite end of the third capacitor Nbst may be connected to the first node N1.

The fourth transistor T4 is connected between the first initialization voltage line VL3 through which the first initialization voltage VINT is applied and the first node N1. The fourth transistor T4 includes a first electrode connected with the first initialization voltage line VL3 through which the first initialization voltage VINT is transferred, a second electrode connected with the first node N1, and a third electrode (e.g., a gate electrode) connected with the j-th initialization scan line GILj. The fourth transistor T4 is turned on in response to the j-th initialization scan signal GIj transferred through the j-th initialization scan line GILj. The turned-on fourth transistor T4 initializes the potential of the third electrode of the first transistor T1 (that is, the potential of the first node N1) by transferring the first initialization voltage VINT to the first node N1.

The fifth transistor T5 includes a first electrode connected with the first drive voltage line VL1, a second electrode connected with the first electrode of the first transistor T1, and a third electrode (e.g., a gate electrode) connected to the j-th emission control line ECLj. The sixth transistor T6 includes a first electrode connected with the second electrode of the first transistor T1, a second electrode connected to the pixel electrode (e.g., a second node N2) of the light-emitting element ED, and a third electrode (e.g., a gate electrode) connected to the j-th emission control line ECLj.

The fifth and sixth transistors T5 and T6 are simultaneously turned on in response to the j-th emission control signal EMj transferred through the j-th emission control line ECLj. The first drive voltage ELVDD applied through the turned-on fifth transistor T5 may be compensated for through the diode-connected first transistor T1 and thereafter may be transferred to the light-emitting element ED through the sixth transistor T6.

The seventh transistor T7 includes a first electrode connected to the second initialization voltage line VL4 through which the second initialization voltage VAINT is transferred, a second electrode connected with the second electrode of the sixth transistor T6, and a third electrode (e.g., a gate electrode) connected with the j-th black scan line GBLj. The second initialization voltage VAINT may have a voltage level lower than or equal to the voltage level of the first initialization voltage VINT.

The one end of the first capacitor Cst is connected with the third electrode of the first transistor T1, and an opposite end of the first capacitor Cst is connected with the first drive voltage line VL1. A cathode of the light-emitting element ED may be connected with the second drive voltage line VL2 that transfers the second drive voltage ELVSS. The second drive voltage ELVSS may have a lower voltage level than that of the first drive voltage ELVDD.

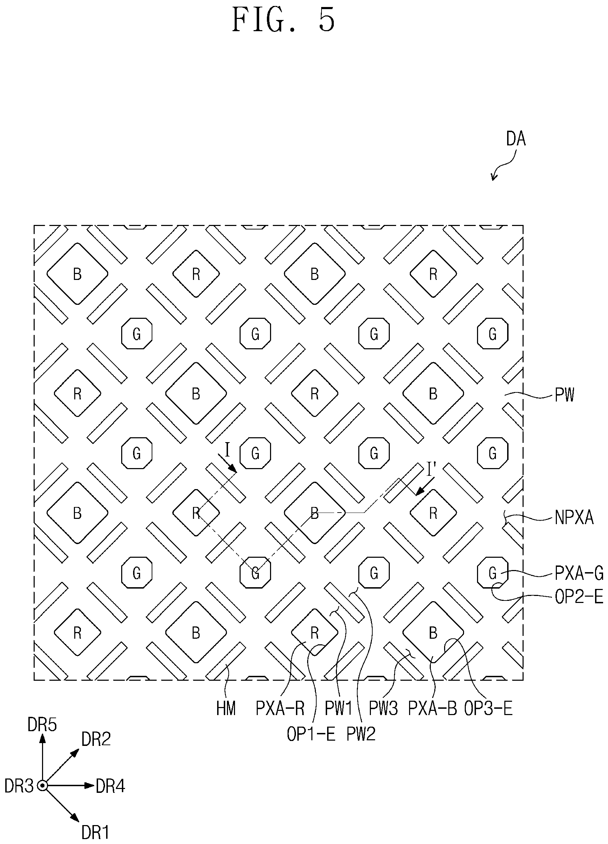

FIG. 5 is an enlarged plan view of an embodiment of a portion of the display region DA (refer to FIG. 2) according to the disclosure. FIG. 5 is a plan view of the display module DM as viewed from above the display surface IS (refer to FIG. 1B) of the display module DM (refer to FIG. 1B) and illustrates an arrangement of emissive regions PXA-R, PXA-G, and PXA-B and the shape of a barrier wall PW.

Referring to FIG. 5, the display region DA may include the first to third emissive regions PXA-R, PXA-G, and PXA-B and a peripheral region NPXA surrounding the first to third emissive regions PXA-R, PXA-G, and PXA-B. The first emissive region PXA-R may be defined as a region exposed by a first light-emitting opening OP1-E, the second emissive region PXA-G may be defined as a region exposed by a second light-emitting opening OP2-E, and the third emissive region PXA-B may be defined as a region exposed by a third light-emitting opening OP3-E.

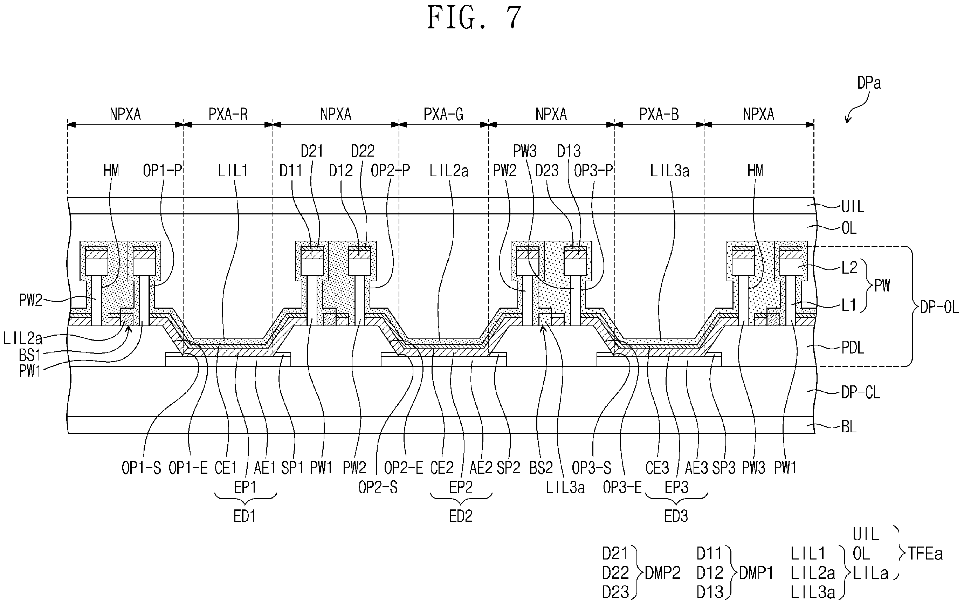

The first to third emissive regions PXA-R, PXA-G, and PXA-B may correspond to regions through which light provided from light-emitting elements ED1, ED2, and ED3 (refer to FIG. 7) is emitted. The first to third emissive regions PXA-R, PXA-G, and PXA-B may be distinguished from one another depending on the colors of lights emitted toward the outside of the display module DM (refer to FIG. 2). The first to third emissive regions PXA-R, PXA-G, and PXA-B may provide first to third color lights having different colors. In an embodiment, the first color light may be red light, the second color light may be green light, and the third color light may be blue light, for example. However, the first to third color lights of the disclosure are not necessarily limited thereto.

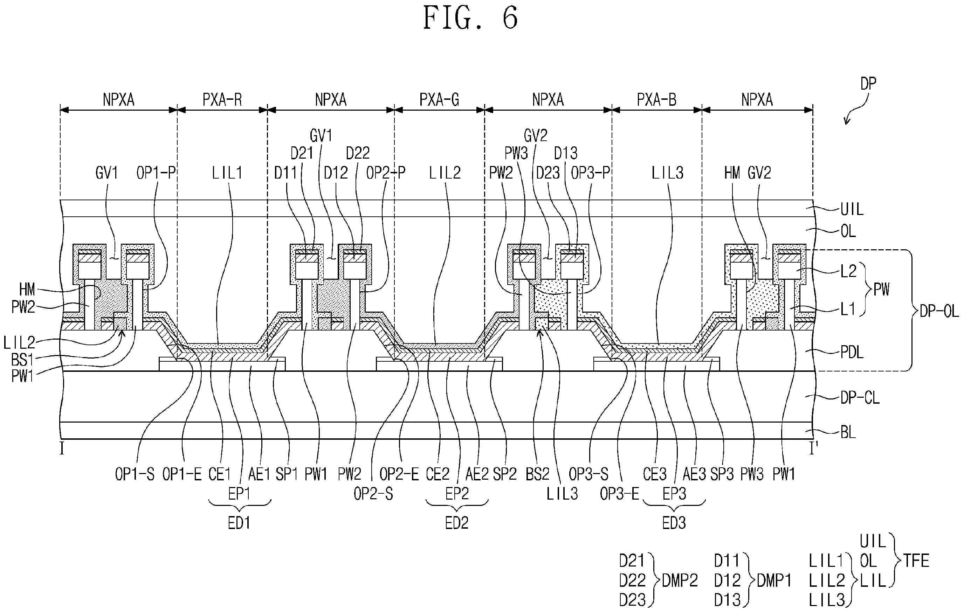

The peripheral region NPXA may set the boundaries between the first to third emissive regions PXA-R, PXA-G, and PXA-B and may prevent color mixing between the first to third emissive regions PXA-R, PXA-G, and PXA-B. The barrier wall PW may be disposed in the peripheral region NPXA. First to third barrier openings OP1-P, OP2-P, and OP3-P (refer to FIG. 6) corresponding to the first to third light-emitting openings OP1-E, OP2-E, and OP3-E may be defined in the barrier wall PW.

The barrier wall PW may include a first barrier wall portion PW1 defining the first barrier opening OP1-P, a second barrier wall portion PW2 defining the second barrier opening OP2-P, and a third barrier wall portion PW3 defining the third barrier opening OP3-P. A recess HM may be defined between the first barrier wall portion PW1 and the second barrier wall portion PW2 and between the second barrier wall portion PW2 and the third barrier wall portion PW3. Detailed description thereabout will be given below.

A plurality of first emissive regions PXA-R, a plurality of second emissive regions PXA-G, and a plurality of third emissive regions PXA-B may be provided. The plurality of first emissive regions PXA-R, the plurality of second emissive regions PXA-G, and the plurality of third emissive regions PXA-B may have a predetermined arrangement in the display region DA and may be repeatedly disposed. In an embodiment, the first and third emissive regions PXA-R and PXA-B may be alternately arranged in a fourth direction DR4 to form a first group, for example. The second emissive regions PXA-G may be arranged in the fourth direction DR4 to form a second group. A plurality of first groups and a plurality of second groups may be provided. The first groups and the second groups may be alternately arranged in a fifth direction DR5. Furthermore, one second emissive region PXA-G may be spaced apart from one first emissive region PXA-R or one third emissive region PXA-B in the second direction DR2. The fourth direction DR4 may be defined as a direction between the first direction DR1 and the second direction DR2, and the fifth direction DR5 may be defined as a direction between the direction opposite to the first direction DR1 and the second direction DR2.

The recess HM of the barrier wall PW, in a plan view, may have a bar shape extending in the first direction DR1 or the second direction DR2. A plurality of recesses HM may be provided. The recesses HM may be arranged in the first direction DR1 or the second direction DR2. The recesses HM may be arranged around the first barrier opening OP1-P (refer to FIG. 6), the second barrier openings OP2-P (refer to FIG. 6) and the third barrier opening OP3-P (refer to FIG. 6). That is, the recesses HM may be arranged in the peripheral region NPXA between the first to third emissive regions PXA-R, PXA-G, and PXA-B.

In FIG. 5, the recesses HM are illustrated as being formed between all the first emissive regions PXA-R and all the second emissive regions PXA-G and between all the second emissive regions PXA-G and all the third emissive regions PXA-B. However, the shape and arrangement of the recesses HM of FIG. 5 are illustrative and are not limited thereto. In an embodiment, the recesses HM may not be defined in some of the spaces between the first emissive regions PXA-R and the second emissive regions PXA-G or some of the spaces between the second emissive regions PXA-G and the third emissive regions PXA-B, for example. Furthermore, in an embodiment, the recesses HM may be defined between the first emissive regions PXA-R and the third emissive regions PXA-B.

FIG. 5 illustrates an arrangement of the first to third emissive regions PXA-R, PXA-G, and PXA-B, and without being limited thereto, the first to third emissive regions PXA-R, PXA-G, and PXA-B may be arranged in various forms. In an embodiment, the first to third emissive regions PXA-R, PXA-G, and PXA-B may have a PENTILE^{™} arrangement as illustrated in FIG. 5. In an alternative embodiment, the first to third emissive regions PXA-R, PXA-G, and PXA-B may have a stripe arrangement or a Diamond Pixel^{™} arrangement.

The first to third emissive regions PXA-R, PXA-G, and PXA-B may have various shapes in the plan view. In an embodiment, the first to third emissive regions PXA-R, PXA-G, and PXA-B may have a polygonal, circular, or oval shape, for example. FIG. 5 illustrates the first and third emissive regions PXA-R and PXA-B having a quadrangular shape (or, a rhombic shape) in the plan view and the second emissive regions PXA-G having an octagonal shape in the plan view.

The first to third emissive regions PXA-R, PXA-G, and PXA-B may have the same shape in the plan view, or at least some of the first to third emissive regions PXA-R, PXA-G, and PXA-B may have different shapes. FIG. 5 illustrates the first and third emissive regions PXA-R and PXA-B having the same shape in the plan view and the second emissive regions PXA-G having a shape different from that of the first and third emissive regions PXA-R and PXA-B.

At least some of the first to third emissive regions PXA-R, PXA-G, and PXA-B may have different areas in the plan view. In an embodiment, the area of the first emissive region PXA-R emitting red light may be greater than the area of the second emissive region PXA-G emitting green light and smaller than the area of the third emissive region PXA-B emitting blue light. However, the relative size relationship between the first to third emissive regions PXA-R, PXA-G, and PXA-B depending on emission colors is not limited thereto and may vary depending on the design of the display module DM (refer to FIG. 2). Furthermore, without being limited thereto, the first to third emissive regions PXA-R, PXA-G, and PXA-B may have the same area in the plan view.

The shapes, areas, and arrangement of the first to third emissive regions PXA-R, PXA-G, and PXA-B of the display module DM (refer to FIG. 2) of the disclosure may be diversely designed depending on the colors of emitted lights or the size and configuration of the display module DM (refer to FIG.2) and are not limited to the embodiment illustrated in FIG. 5.

FIG. 6 is a cross-sectional view of the display panel DP taken along line I-I' of FIG. 5.

Referring to FIGS. 5 and 6, the display panel DP may include the base layer BL, the circuit element layer DP-CL, the display element layer DP-OL, and the thin film encapsulation layer TFE.

The display panel DP may include a plurality of insulating layers, a semiconductor pattern, a conductive pattern, and a signal line. An insulating layer, a semiconductor layer, and a conductive layer are formed by coating, deposition, or the like. Thereafter, the insulating layer, the semiconductor layer, and the conductive layer may be selectively subjected to patterning by photolithography and etching. The semiconductor pattern, the conductive pattern, and the signal line included in the circuit element layer DP-CL and the display element layer DP-OL are formed by the above-described method.

Although the circuit element layer DP-CL is illustrated as a single layer, the circuit element layer DP-CL is simply illustrated for ease of description. The circuit element layer DP-CL may include an insulating layer, a semiconductor pattern, a conductive pattern, or the like for forming various elements.

A plurality of pixel drive circuits may be provided in the circuit element layer DP-CL. The pixel drive circuits may be connected to the light-emitting elements ED1, ED2, and ED3, respectively, and may independently control the light-emitting elements ED1, ED2, and ED3. Each of the pixel drive circuits may include a plurality of transistors for driving a connected light-emitting element, at least one capacitor, and signal lines connecting the transistors and the capacitor.

The display element layer DP-OL may be disposed on the circuit element layer DP-CL. According to this embodiment, the display element layer DP-OL may include the light-emitting elements ED1, ED2, and ED3, a pixel defining layer PDL, the barrier wall PW, and dummy patterns DMP1 and DMP2.

The light-emitting elements ED1, ED2, and ED3 include the first light-emitting element ED1, the second light-emitting element ED2, and the third light-emitting element ED3. Each of the light-emitting elements ED1, ED2, and ED3 includes an anode, a cathode, and an emission pattern disposed between the anode and the cathode. The first light-emitting element ED1 may include a first anode AE1, a first cathode CE1, and a first emission pattern EP1, the second light-emitting element ED2 may include a second anode AE2, a second cathode CE2, and a second emission pattern EP2, and the third light-emitting element ED3 may include a third anode AE3, a third cathode CE3, and a third emission pattern EP3.

The first to third anodes AE1, AE2, and AE3 may be disposed on the circuit element layer DP-CL. The first to third anodes AE1, AE2, and AE3 may be provided in a plurality of patterns. The first to third anodes AE1, AE2, and AE3 may have conductivity. In an embodiment, as long as the first to third anodes AE1, AE2, and AE3 are capable of having conductivity, the first to third anodes AE1, AE2, and AE3 may include or consist of various materials such as metal, transparent conductive oxide ("TCO"), or a conductive polymer material, for example. In an embodiment, the first to third anodes AE1, AE2, and AE3, which are metals, may include gold (Au), silver (Ag), aluminium (Al), magnesium (Mg), lithium (Li), molybdenum (Mo), copper (Cu), or any alloys thereof, for example. The first to third anodes AE1, AE2, and AE3, which are TCOs, may include indium tin oxide ("ITO"), indium zinc oxide ("IZO"), zinc oxide (ZnO), indium oxide (InO), indium gallium oxide ("IGO"), or aluminium zinc oxide ("AZO").

Each of the first to third anodes AE1, AE2, and AE3 is illustrated as a single layer. However, this is illustrative, and each of the first to third anodes AE1, AE2, and AE3 may have a multi-layer structure. In an alternative embodiment, one of the first to third anodes AE1, AE2, and AE3 may have a single-layer structure, and another one may have a multi-layer structure. The disclosure is not limited to any particular embodiment.

The first to third emission patterns EP1, EP2, and EP3 may be disposed on the first to third anodes AE1, AE2, and AE3, respectively. The first to third emission patterns EP1, EP2, and EP3 may be patterned by tip portions defined on the barrier wall PW to be described below. In an embodiment, the first emission pattern EP1 may provide red light, the second emission pattern EP2 may provide green light, and the third emission pattern EP3 may provide blue light.

Each of the first to third emission patterns EP1, EP2, and EP3 may include an emissive layer including a luminescent material. Each of the first to third emission patterns EP1, EP2, and EP3 may further include a hole injection layer ("HII,") and a hole transport layer ("HTL") that are disposed between a corresponding anode among the first to third anodes AE1, AE2, and AE3 and the emissive layer and may further include an electron transport layer ("ETL") and an electron injection layer ("EIL") that are disposed on the emissive layer. The first to third emission patterns EP1, EP2, and EP3 may be also referred to as the first to third organic layers or the first to third intermediate layers, respectively.

Each of the first to third cathodes CE1, CE2, and CE3 may be disposed on a corresponding emission pattern among the first to third emission patterns EP1, EP2, and EP3. The first to third cathodes CE1, CE2, and CE3 may be patterned by the tip portions defined on the barrier wall PW to be described below. The first to third cathodes CE1, CE2, and CE3 may have conductivity. In an embodiment, as long as the first to third cathodes CE1, CE2, and CE3 are capable of having conductivity, the first to third cathodes CE1, CE2, and CE3 may include or consist of various materials such as metal, TCO, or a conductive polymer material, for example.

The pixel defining layer PDL may be disposed on an insulating layer disposed at the top of the circuit element layer DP-CL. The first to third light-emitting openings OP1-E, OP2-E, and OP3-E may be defined in the pixel defining layer PDL. The first to third light-emitting openings OP1-E, OP2-E, and OP3-E may correspond to the first to third anodes AE1, AE2, and AE3, respectively. The pixel defining layer PDL may expose at least portions of the first to third anodes AE1, AE2, and AE3 through the light-emitting openings OP1-E, OP2-E, and OP3-E.

The first emissive region PXA-R may be defined as a region of an upper surface of the first anode AE1 that is exposed by the first light-emitting opening OP1-E, the second emissive region PXA-G may be defined as a region of an upper surface of the second anode AE2 that is exposed by the second light-emitting opening OP2-E, and the third emissive region PXA-B may be defined as a region of an upper surface of the third anode AE3 that is exposed by the third light-emitting opening OP3-E.

The pixel defining layer PDL may be an inorganic insulating layer. In an embodiment, the pixel defining layer PDL may include silicon oxide, silicon nitride, or any combinations thereof, for example. In an embodiment, the pixel defining layer PDL may have a two-layer structure in which a silicon oxide layer and a silicon nitride layer are sequentially stacked, for example. However, this is illustrative, and as long as the pixel defining layer PDL is an inorganic insulating layer, the pixel defining layer PDL may include or consist of various materials and may have a single-layer structure or a multi-layer structure, and the disclosure is not limited to any particular embodiment.

According to the disclosure, the display panel DP may further include first to third sacrificial patterns SP1, SP2, and SP3. The first to third sacrificial patterns SP1, SP2, and SP3 may be disposed on the upper surfaces of the first to third anodes AE1, AE2, and AE3, respectively. The first to third sacrificial patterns SP1, SP2, and SP3 may be covered by the pixel defining layer PDL. The first to third sacrificial patterns SP1, SP2, and SP3 expose at least portions of the corresponding anodes AE1, AE2, and AE3, respectively. The first to third sacrificial patterns SP1, SP2, and SP3 may be disposed in positions not overlapping the light-emitting openings OP1-E, OP2-E, and OP3-E, respectively.

In the case in which the display panel DP further includes the first to third sacrificial patterns SP1, SP2, and SP3, the upper surfaces of the first to third anodes AE1, AE2, and AE3 may be spaced apart from the pixel defining layer PDL in the plan view with the corresponding sacrificial patterns SP1, SP2, and SP3 therebetween. Accordingly, damage to the first to third anodes AE1, AE2, and AE3 may be prevented in a process of forming the light-emitting openings OP1-E, OP2-E, and OP3-E.

In an embodiment, sacrificial openings OP1-S, OP2-S, and OP3-S corresponding to the light-emitting openings OP1-E, OP2-E, and OP3-E may be defined in the first to third sacrificial patterns SP1, SP2, and SP3. The emissive regions PXA-R, PXA-G, and PXA-B may be regions of the first to third anodes AE1, AE2, and AE3 exposed through the corresponding sacrificial openings OP1-S, OP2-S, and OP3-S. Although FIG. 6 illustrates one example that inner surfaces of the first to third sacrificial patterns SP1, SP2, and SP3 that define the sacrificial openings OP1-S, OP2-S, and OP3-S and an inner surface of the pixel defining layer PDL that defines the corresponding light-emitting openings OP1-E, OP2-E, and OP3-E are substantially aligned, the disclosure is not limited thereto. In an embodiment, the sacrificial openings OP1-S, OP2-S, and OP3-S may have larger areas than the corresponding light-emitting openings OP1-E, OP2-E, and OP3-E, for example.

The barrier wall PW is disposed on the pixel defining layer PDL. The barrier wall PW may include the first barrier wall portion PW1, the second barrier wall portion PW2, and the third barrier wall portion PW3. The first barrier wall portion PW1 may define the first barrier openings OP1-P, the second barrier wall portion PW2 may define the second barrier opening OP2-P, and the third barrier wall portion PW3 may define the third barrier openings OP3-P. The recesses HM may be defined between the first barrier wall portion PW1 and the second barrier wall portion PW2, between the second barrier wall portion PW2 and the third barrier wall portion PW3, and between the first barrier wall portion PW1 and the third barrier wall portion PW3. However, this is illustrative, and the recesses HM may not be defined in some of the spaces between the first to third barrier wall portions PW1, PW2, and PW3.

Portions of the first to third emission patterns EP1, EP2, and EP3, portions of the first to third cathodes CE1, CE2, and CE3, and portions of a lower encapsulation layer LIL may be disposed in the recesses HM. Specifically, the second emission pattern EP2, the second cathode CE2, a first lower inorganic encapsulation pattern LIL1, and a second lower inorganic encapsulation pattern LIL2 may be disposed in the recess HM between the first barrier wall portion PW1 and the second barrier wall portion PW2. The third emission pattern EP3, the third cathode CE3, the second lower inorganic encapsulation pattern LIL2, and a third lower inorganic encapsulation pattern LIL3 may be disposed in the recess HM between the second barrier wall portion PW2 and the third barrier wall portion PW3. The third emission pattern EP3, the third cathode CE3, and the first to third lower inorganic encapsulation patterns LIL1, LIL2, and LIL3 may be disposed in the recess HM between the first barrier wall portion PW1 and the third barrier wall portion PW3. However, this is illustrative, and components disposed in the recesses HM are not limited thereto. In an embodiment, components disposed in the recesses HM may vary depending on the order in which the first to third light-emitting elements ED1, ED2, and ED3 are formed, for example.

In an embodiment, emission patterns including or consisting of an organic material may be removed in an etching process. As the emission patterns are partially removed, a thin film encapsulation layer disposed on the emission patterns may be stripped, and a moisture permeation path may be formed to cause oxidation of cathodes. Therefore, the display device may have a defect.

According to the disclosure, portions of the first to third emission patterns EP1, EP2, and EP3 (hereinafter, also referred to as the sacrificial emission patterns) may be separately formed in the recesses HM between the first to third barrier wall portions PW1, PW2, and PW3, and in the recesses HM, the lower encapsulation layer LIL may be formed on the sacrificial emission patterns EP1, EP2, and EP3. Even though the sacrificial emission patterns EP1, EP2, and EP3 are lost in an etching process, portions of the lower encapsulation layer LIL disposed in the recesses HM of the barrier wall PW may be fixed by the tip portions of the barrier wall PW, and thus the shape of the thin film encapsulation layer TFE may be maintained. Accordingly, oxidation of the first to third cathodes CE1, CE2, and CE3 may be prevented by blocking a moisture permeation path into the light-emitting elements ED1, ED2, and ED3, and thus the reliability of the display device DD may be improved.

The first to third barrier openings OP1-P, OP2-P, and OP3-P may correspond to the first to third light-emitting openings OP1-E, OP2-E, and OP3-E, respectively. Each of the first to third barrier openings OP1-P, OP2-P, and OP3-P may form an integrated opening space with a corresponding light-emitting opening. The first to third barrier openings OP1-P, OP2-P, and OP3-P and the light-emitting openings OP1-E, OP2-E, and OP3-E integrated with each other may expose at least portions of the corresponding anodes AE1, AE2, and AE3.

The barrier wall PW may have an undercut shape on the section. The barrier wall PW may include multiple layers sequentially stacked one above another, and at least one layer among the multiple layers may be recessed relative to layers stacked adjacent thereto. Accordingly, the barrier wall PW may include the tip portions.

The emission patterns EP1, EP2, and EP3 and the first to third cathodes CE1, CE2, and CE3 may be separated by the tip portions of the barrier wall PW and may be formed in the light-emitting openings OP1-E, OP2-E, and OP3-E and the first to third barrier openings OP1-P, OP2-P, and OP3-P.

According to this embodiment, the barrier wall PW may include a first layer L1 and a second layer L2 disposed on the first layer L1. The first layer L1 may be disposed on the pixel defining layer PDL. When compared to the second layer L2, the first layer L1 may be relatively recessed with respect to the emissive regions PXA-R, PXA-G, and PXA-B. That is, the first layer L1 may be undercut with respect to the second layer L2. Portions of the second layer L2 that protrude from the first layer L1 toward the emissive regions PXA-R, PXA-G, and PXA-B may be defined as the tip portions.

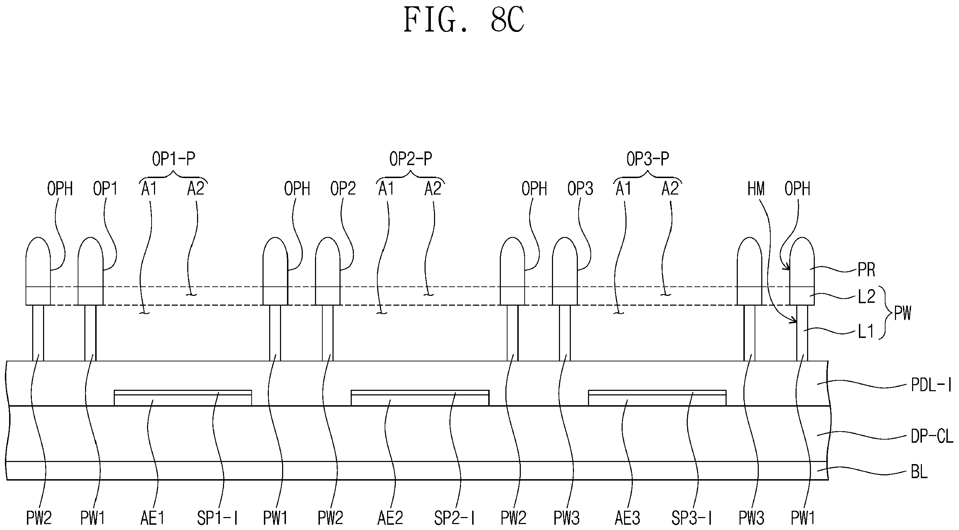

Each of the first to third barrier openings OP1-P, OP2-P, and OP3-P defined in the barrier wall PW may include a first region A1 (refer to FIG. 8C) and a second region A2 (refer to FIG. 8C). The first layer L1 may include inner surfaces that define the first regions A1 of the first to third barrier openings OP1-P, OP2-P, and OP3-P, and the second layer L2 may include inner surfaces that define the second regions A2 of the first to third barrier openings OP1-P, OP2-P, and OP3-P.

The first layer L1 may include a conductive material. The conductive material may include metal, TCO, or any combinations thereof. In an embodiment, the metal may include gold (Au), silver (Ag), aluminium (Al), magnesium (Mg), lithium (Li), molybdenum (Mo), titanium (Ti), copper (Cu), or any alloys thereof, for example. The TCO may include indium tin oxide ("ITO"), indium zinc oxide ("IZO"), zinc oxide, indium oxide, indium gallium oxide, indium gallium zinc oxide ("IGZO"), or aluminium zinc oxide.

The second layer L2 may include metal or non-metal. In an embodiment, the metal may include gold (Au), silver (Ag), aluminium (Al), magnesium (Mg), lithium (Li), molybdenum (Mo), titanium (Ti), copper (Cu), or any alloys thereof, for example. The nonmetal may include silicon (Si), silicon oxide (SiOx), silicon nitride (SiNx), silicon oxy-nitride (SiON), metal oxide, metal nitride, or any combinations thereof, and the metal oxide may include TCO.

In an embodiment, the barrier wall PW may further include layers that are disposed below the first layer L1, above the second layer L2, or between the first layer L1 and the second layer L2. In this case, the additionally disposed layers may include at least one of the conductive material and the inorganic material.

The barrier wall PW may receive the second drive voltage ELVSS (refer to FIG. 3). As the first to third cathodes CE1, CE2, and CE3 are brought into direct contact with the barrier wall PW, the first to third cathodes CE1, CE2, and CE3 may be electrically connected with the barrier wall PW and may receive the second drive voltage ELVSS.

The first layer L1 may have a greater thickness than the second layer L2. The first layer L1 may be brought into direct contact with the first to third cathodes CE1, CE2, and CE3. The first to third cathodes CE1, CE2, and CE3 may be physically separated by the second layer L2 that forms the tip portions and may be formed in the light-emitting openings OP1-E, OP2-E, and OP3-E. The first to third cathodes CE1, CE2, and CE3 may contact the first layer L1 and may be electrically connected with the first layer L1 to receive a common voltage. The first layer L1 may have a higher electrical conductivity and a greater thickness than the second layer L2 and thus may decrease contact resistance with the first to third cathodes CE1, CE2, and CE3. Accordingly, a common cathode voltage may be uniformly provided for the emissive regions PXA-R, PXA-G, and PXA-B.

The plurality of emission patterns EP1, EP2, and EP3 may be patterned and deposited in pixel units by the tip portions defined on the barrier wall PW. That is, the emission patterns EP1, EP2, and EP3 may be commonly formed by an open mask, but may be easily divided in pixel units by the barrier wall PW.

In contrast, in a case in which emission patterns are patterned by a fine metal mask ("FMM"), a spacer for support that protrudes from a barrier wall has to be provided to support the fine metal mask. Furthermore, since the fine metal mask is spaced, by the height of the barrier wall and the spacer, apart from a base surface on which the patterning is performed, there may be a limitation in the implementation of relatively high resolution. In addition, since the fine metal mask is brought into contact with the spacer, foreign matter may remain on the spacer after the patterning process of the emission patterns, or the spacer may be damaged by a dent defect of the fine metal mask. Therefore, a defective display panel may be formed.

According to this embodiment, since the barrier wall PW is included, the physical separation between the light-emitting elements ED1, ED2, and ED3 may be easily achieved. Accordingly, current leakage or a driving error between the adjacent emissive regions PXA-R, PXA-G, and PXA-B may be prevented, and the light-emitting elements ED1, ED2, and ED3 may be independently driven.

In particular, by patterning the plurality of emission patterns EP1, EP2, and EP3 without a mask in contact with an internal component in the display region DA (refer to FIG. 2), a defect rate may be reduced, and thus the display panel DP having improved process reliability may be provided. Since patterning is possible even though a separate spacer for support that protrudes from the barrier wall PW is not provided, the areas of the emissive regions PXA-R, PXA-G, and PXA-B may be scaled down, and thus the display panel DP capable of easily implementing relatively high resolution may be provided.

In FIG. 6, the emission patterns EP1, EP2, and EP3 are illustrated as contacting the inner surfaces of the first layer L1. However, the disclosure is not limited thereto. In an embodiment, the emission patterns EP1, EP2, and EP3 may not contact the inner surfaces of the first layer L1, and only the first to third cathodes CE1, CE2, and CE3 may contact the inner surfaces of the first layer L1, for example.

The dummy patterns DMP1 and DMP2 may be disposed on the barrier wall PW. The dummy patterns DMP1 and DMP2 may include the first dummy patterns DMP1 and the second dummy patterns DMP2.

The first dummy patterns DMP1 may be disposed on the upper surface of the second layer L2. The first dummy patterns DMP1 may include a 1-1 dummy pattern D11, a 1-2 dummy pattern D12, and a 1-3 dummy pattern D13. The 1-1 dummy pattern D11, the 1-2 dummy pattern D12, and the 1-3 dummy pattern D13 may have closed-line shapes that surround the first to third emissive regions PXA-R, PXA-G, and PXA-B, respectively, in the plan view.

The first dummy patterns DMP1 may include an organic material. The 1-1 dummy pattern D11, the 1-2 dummy pattern D12, and the 1-3 dummy pattern D13 may include the same material as that of the first to third emission patterns EP1, EP2, and EP3 and may be formed through the same process as the first to third emission patterns EP1, EP2, and EP3. Each of the first dummy patterns DMP1 may be simultaneously formed with a corresponding emission pattern through one process and may be separated from the corresponding emission pattern by the undercut shape of the barrier wall PW.

Although FIG. 6 illustrates one example that an inner surface of the 1-1 dummy pattern D11 is aligned with an inner surface of the second layer L2 that defines the second region of the first barrier opening OP1-P, the disclosure is not limited thereto. In an embodiment, the 1-1 dummy pattern D11 may cover the inner surface of the second layer L2, for example. This description may be similarly applied to the 1-2 dummy pattern D12 and the 1-3 dummy pattern D13.

The second dummy patterns DMP2 may be disposed on the first dummy patterns DMP1. The second dummy patterns DMP2 may include a 2-1 dummy pattern D21, a 2-2 dummy pattern D22, and a 2-3 dummy pattern D23. Openings may be defined in the 2-1 dummy pattern D21, the 2-2 dummy pattern D22, and the 2-3 dummy pattern D23, respectively. The openings may extend from openings of the 1-1 dummy pattern D11, the 1-2 dummy pattern D12, and the 1-3 dummy pattern D13 to form integrated opening spaces. The 2-1 dummy pattern D21, the 2-2 dummy pattern D22, and the 2-3 dummy pattern D23 may have closed-line shapes that surround the first to third emissive regions PXA-R, PXA-G, and PXA-B, respectively, in the plan view.

The second dummy patterns DMP2 may include a conductive material. The 2-1 dummy pattern D21, the 2-2 dummy pattern D22, and the 2-3 dummy pattern D23 may include the same material as that of the first to third cathodes CE1, CE2, and CE3. The 2-1 dummy pattern D21, the 2-2 dummy pattern D22, and the 2-3 dummy pattern D23 may be formed through the same process as the first to third cathodes CE1, CE2, and CE3. Each of the second dummy patterns DMP2 may be simultaneously formed with a corresponding cathode through one process and may be separated from the corresponding cathode by the undercut shape of the barrier wall PW.

The thin film encapsulation layer TFE may be disposed on the display element layer DP-OL. The thin film encapsulation layer TFE may include the lower encapsulation layer LIL, an organic encapsulation film OL, and an upper inorganic encapsulation film UIL.

The lower encapsulation layer LIL may cover the first to third light-emitting elements ED1, ED2, and ED3. The lower encapsulation layer LIL may include the first lower inorganic encapsulation pattern LIL1, the second lower inorganic encapsulation pattern LIL2, and the third lower inorganic encapsulation pattern LIL3.

The first lower inorganic encapsulation pattern LIL1 may overlap the first light-emitting opening OP1-E. One portion of the first lower inorganic encapsulation pattern LIL1 may be disposed in the first barrier opening OP1-P and may cover the first light-emitting element ED1, and another portion of the first lower inorganic encapsulation pattern LIL1 may be disposed on the first barrier wall portion PW1. Specifically, the first lower inorganic encapsulation pattern LIL1 may be disposed on the 2-1 dummy pattern D21. The remaining portion of the first lower inorganic encapsulation pattern LIL1 may be disposed in the recesses HM along a side surface of the first barrier wall portion PW1 and may cover the first barrier wall portion PW1. That is, at least a portion of the first lower inorganic encapsulation pattern LIL1 may be accommodated in the recesses HM.

The second lower inorganic encapsulation pattern LIL2 may overlap the second light-emitting opening OP2-E. One portion of the second lower inorganic encapsulation pattern LIL2 may be disposed in the second barrier opening OP2-P and may cover the second light-emitting element ED2, and another portion of the second lower inorganic encapsulation pattern LIL2 may be disposed on the second barrier wall portion PW2. Specifically, the second lower inorganic encapsulation pattern LIL2 may be disposed on the 2-2 dummy pattern D22. The remaining portion of the second lower inorganic encapsulation pattern LIL2 may be disposed in the recesses HM along a side surface of the second barrier wall portion PW2 and may cover a portion of the first lower inorganic encapsulation pattern LIL1 and the second cathode CE2. That is, at least a portion of the second lower inorganic encapsulation pattern LIL2 may be accommodated in the recesses HM.

The third lower inorganic encapsulation pattern LIL3 may overlap the third light-emitting opening OP3-E. One portion of the third lower inorganic encapsulation pattern LIL3 may be disposed in the third barrier opening OP3-P and may cover the third light-emitting element ED3, and another portion of the third lower inorganic encapsulation pattern LIL3 may be disposed on the third barrier wall portion PW3. Specifically, the third lower inorganic encapsulation pattern LIL3 may be disposed on the 2-3 dummy pattern D23. The remaining portion of the third lower inorganic encapsulation pattern LIL3 may be disposed in the recesses HM along a side surface of the third barrier wall portion PW3 and may cover the first lower inorganic encapsulation pattern LIL1 and the third cathode CE3, or a portion of the second lower inorganic encapsulation pattern LIL2 and the third cathode CE3. That is, at least a portion of the third lower inorganic encapsulation pattern LIL3 may be accommodated in the recesses HM.

A first groove GV1 may be defined in the thickness direction of the barrier wall PW in the recess HM between the first barrier wall portion PW1 and the second barrier wall portion PW2. One portion of a side surface that defines the first groove GV1 may be defined by the first lower inorganic encapsulation pattern LIL1, and another portion of the side surface may be defined by the second lower inorganic encapsulation pattern LIL2. That is, in the recess HM, one portion of the first lower inorganic encapsulation pattern LII,1 and one portion of the second lower inorganic encapsulation pattern LIL2 may contact each other, and another portion of the first lower inorganic encapsulation pattern LII,1 and another portion of the second lower inorganic encapsulation pattern LIL2 may be spaced apart from each other in one direction.

A second groove GV2 may be defined in the thickness direction of the barrier wall PW in the recess HM between the second barrier wall portion PW2 and the third barrier wall portion PW3. One portion of a side surface that defines the second groove GV2 may be defined by the second lower inorganic encapsulation pattern LIL2, and another portion of the side surface may be defined by the third lower inorganic encapsulation pattern LIL3. That is, in the recess HM, one portion of the second lower inorganic encapsulation pattern LIL2 and one portion of the third lower inorganic encapsulation pattern LIL3 may contact each other, and another portion of the second lower inorganic encapsulation pattern LIL2 and another portion of the third lower inorganic encapsulation pattern LIL3 may be spaced apart from each other in one direction.

A second groove GV2 may be defined in the thickness direction of the barrier wall PW in the recess HM between the first barrier wall portion PW1 and the third barrier wall portion PW3. One portion of a side surface that defines the second groove GV2 may be defined by the first lower inorganic encapsulation pattern LIL1, and another portion of the side surface may be defined by the third lower inorganic encapsulation pattern LIL3. That is, in the recess HM, one portion of the first lower inorganic encapsulation pattern LIL1 and one portion of the third lower inorganic encapsulation pattern LIL3 may contact each other, and another portion of the first lower inorganic encapsulation pattern LIL1 and another portion of the third lower inorganic encapsulation pattern LIL3 may be spaced apart from each other in one direction.

Furthermore, in the recess HM between the first barrier wall portion PW1 and the second barrier wall portion PW2 and the recess HM between the first barrier wall portion PW1 and the third barrier wall portion PW3, a first space BS1 may be defined between one portion of the first lower inorganic encapsulation pattern LII,1 and the pixel defining layer PDL, and one portion of the second lower inorganic encapsulation pattern LIL2 may be disposed in the first space BS1. In the recess HM between the second barrier wall portion PW2 and the third barrier wall portion PW3, a second space BS2 may be defined between one portion of the second lower inorganic encapsulation pattern LIL2 and the pixel defining layer PDL, and one portion of the third lower inorganic encapsulation pattern LIL3 may be disposed in the second space BS2.

The organic encapsulation film OL may cover the first to third lower inorganic encapsulation patterns LIL1, LIL2, and LIL3 and may provide a flat upper surface. The upper inorganic encapsulation film UIL may be disposed on the organic encapsulation film OL.

The first to third lower inorganic encapsulation patterns LIL1, LIL2, and LIL3 and the upper inorganic encapsulation film UIL may protect the display element layer DP-OL from moisture/oxygen, and the organic encapsulation film OL may protect the display element layer DP-OL from foreign matter such as dust particles.

FIG. 7 is a cross-sectional view of the display panel DP taken along line I-I' of FIG. 5. In describing FIG. 7, the description will be made with reference to FIG. 6, and descriptions of the same reference numerals will be omitted.

Referring to FIGS. 6 and 7, a display panel DPa may include a base layer BL, a circuit element layer DP-CL, a display element layer DP-OL, and a thin film encapsulation layer TFEa. The thin film encapsulation layer TFEa may include a lower encapsulation layer LILa, an organic encapsulation film OL, and an upper inorganic encapsulation film UIL. The lower encapsulation layer LILa may include a first lower inorganic encapsulation pattern LIL1, a second lower inorganic encapsulation pattern LIL2a, and a third lower inorganic encapsulation pattern LIL3a.

The second lower inorganic encapsulation pattern LIL2a may overlap a second light-emitting opening OP2-E. One portion of the second lower inorganic encapsulation pattern LIL2a may be disposed in a second barrier opening OP2-P and may cover a second light-emitting element ED2, and another portion of the second lower inorganic encapsulation pattern LIL2a may be disposed on a second barrier wall portion PW2. Specifically, the second lower inorganic encapsulation pattern LIL2a may be disposed on a 2-2 dummy pattern D22. The remaining portion of the second lower inorganic encapsulation pattern LIL2a may be disposed in recesses HM and may cover a portion of the first lower inorganic encapsulation pattern LIL1 and a second cathode CE2. That is, at least a portion of the second lower inorganic encapsulation pattern LIL2a may be accommodated in the recesses HM.

The third lower inorganic encapsulation pattern LIL3a may overlap a third light-emitting opening OP3-E. One portion of the third lower inorganic encapsulation pattern LIL3a may be disposed in a third barrier opening OP3-P and may cover a third light-emitting element ED3, and another portion of the third lower inorganic encapsulation pattern LIL3a may be disposed on a third barrier wall portion PW3. Specifically, the third lower inorganic encapsulation pattern LIL3a may be disposed on a 2-3 dummy pattern D23. The remaining portion of the third lower inorganic encapsulation pattern LIL3a may be disposed in recesses HM and may cover the first lower inorganic encapsulation pattern LIL1 and a third cathode CE3, or a portion of the second lower inorganic encapsulation pattern LIL2a and the third cathode CE3. That is, at least a portion of the third lower inorganic encapsulation pattern LIL3a may be accommodated in the recesses HM.

Upper surfaces of the lower encapsulation layer LILa that overlap the recesses HM may be flat. In an embodiment, an upper surface of the first lower inorganic encapsulation pattern LIL1 and an upper surface of the second lower inorganic encapsulation pattern LIL2a that overlap the recess HM between the first barrier wall portion PW1 and the second barrier wall portion PW2 may be aligned with each other, for example. An upper surface of the second lower inorganic encapsulation pattern LIL2a and an upper surface of the third lower inorganic encapsulation pattern LIL3a that overlap the recess HM between the second barrier wall portion PW2 and the third barrier wall portion PW3 may be aligned with each other. An upper surface of the first lower inorganic encapsulation pattern LIL1 and an upper surface of the third lower inorganic encapsulation pattern LIL3a that overlap the recess HM between the first barrier wall portion PW1 and the third barrier wall portion PW3 may be aligned with each other.

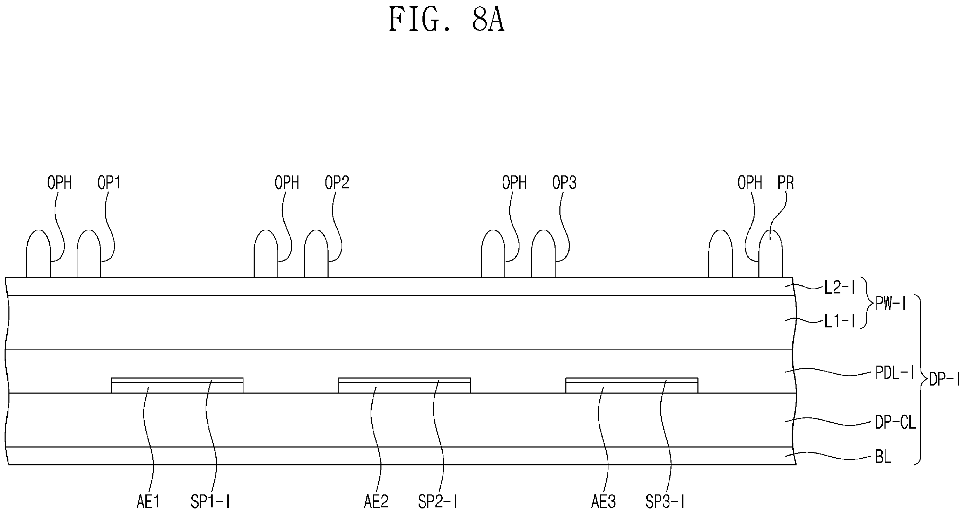

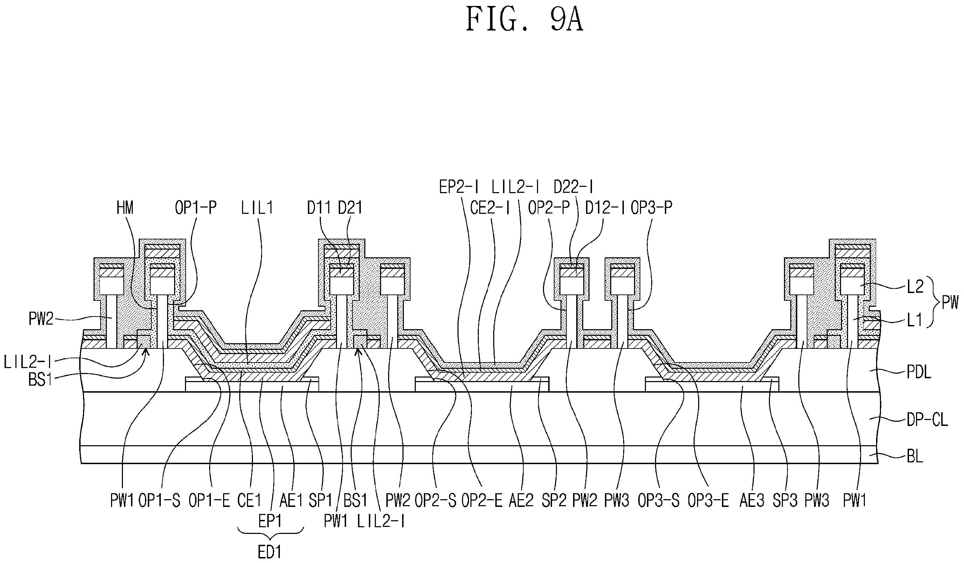

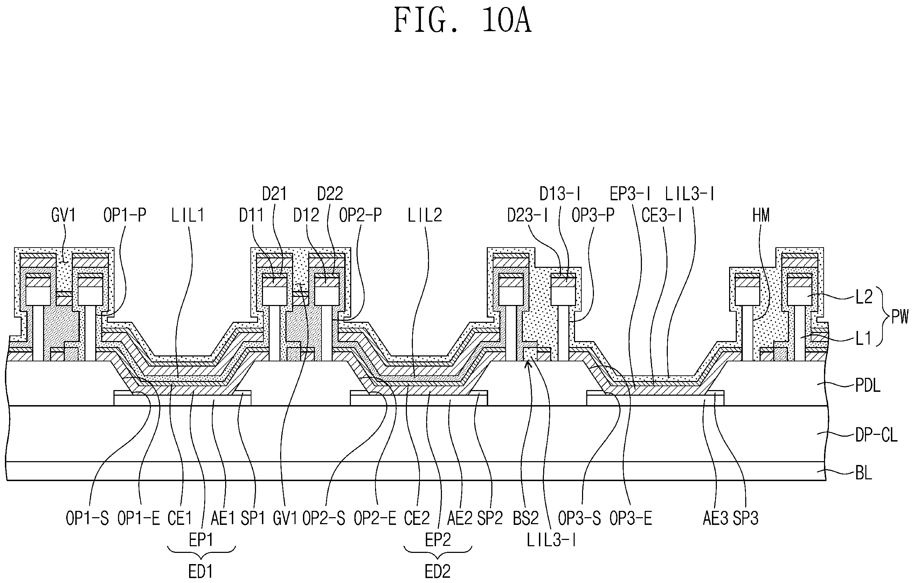

FIGS. 8A to 8G are cross-sectional views illustrating an embodiment of some of operations of a display panel manufacturing method according to the disclosure. FIGS. 9A to 9C are cross-sectional views illustrating an embodiment of some of the operations of the display panel manufacturing method according to the disclosure. FIGS. 10A to 10D are cross-sectional views illustrating an embodiment of some of the operations of the display panel manufacturing method according to the disclosure. In describing FIGS. 8A to 8G, 9A to 9C, and 10A to 10D, the description will be made with reference to FIG. 6, and descriptions of the same reference numerals will be omitted.

The display panel manufacturing method according to the disclosure includes an operation of providing a preliminary display panel that includes a base layer, a first anode disposed on the base layer, a second anode disposed on the base layer, a preliminary pixel defining layer that is disposed on the base layer and that covers the first anode and the second anode, and a preliminary barrier wall, an operation of forming a barrier wall by etching the preliminary barrier wall, the barrier wall including a first barrier opening overlapping the first anode, a second barrier opening overlapping the second anode, and a recess between the first barrier opening and the second barrier opening, an operation of forming a pixel defining layer by etching the preliminary pixel defining layer, the pixel defining layer including a first light-emitting opening that exposes a portion of the first anode and a second light-emitting opening that exposes a portion of the second anode, an operation of forming a first emission pattern and a first cathode in the first light-emitting opening, an operation of forming a first lower inorganic encapsulation pattern that covers the first barrier opening and that is at least partially accommodated in the recess, an operation of forming a second emission pattern and a second cathode in the second light-emitting opening, and an operation of forming a second lower inorganic encapsulation pattern that covers the second barrier opening and that is at least partially accommodated in the recess.

The display panel manufacturing method according to the disclosure may include a first group process, a second group process, a third group process, and a fourth group process. The first to third group processes may be processes of forming the first to third light-emitting elements ED1, ED2, and ED3 (refer to FIG. 6) and some components of the lower encapsulation layer LIL (refer to FIG. 6), and the fourth group process may be a process of completing the display panel DP (refer to FIG. 6) by forming the remaining components of the thin film encapsulation layer TFE (refer to FIG. 6).

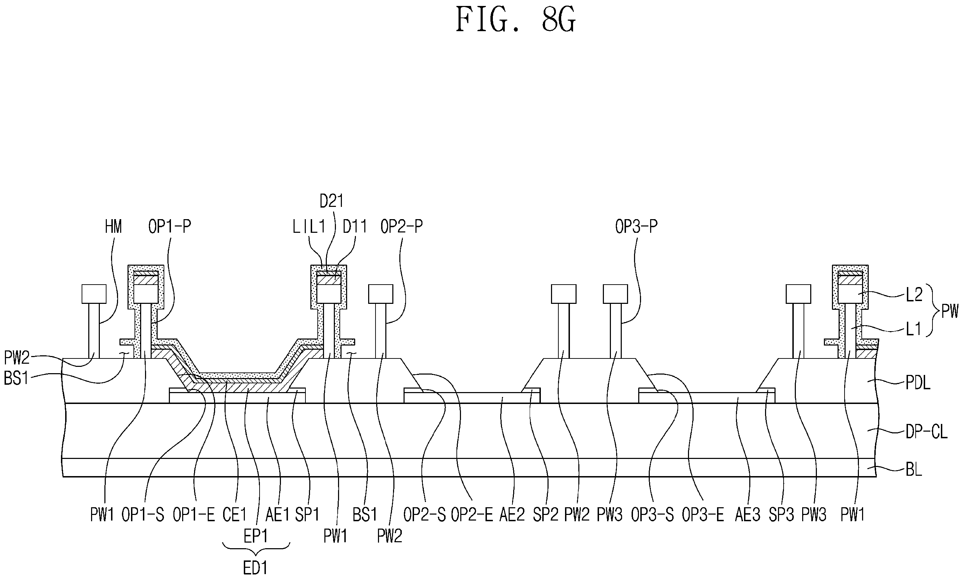

In this embodiment, the first light-emitting element ED1 (refer to FIG. 8G) and the first lower inorganic encapsulation pattern LIL1 (refer to FIG. 8G) that covers the first light-emitting element ED1 may be formed through the first group process. Hereinafter, the first group process will be described with reference to FIGS. 8A and 8G.

Referring to FIG. 8A, the first group process may include an operation of forming a first photoresist layer on a preliminary display panel DP-I. The preliminary display panel DP-I may include the base layer BL, the circuit element layer DP-CL, the first to third anodes AE1, AE2, and AE3, first to third preliminary sacrificial patterns SP1-I, SP2-I, and SP3-I, a preliminary pixel defining layer PDL-I, and a preliminary barrier wall PW-I.

The circuit element layer DP-CL may be disposed on the base layer BL. The circuit element layer DP-CL may be formed through a conventional circuit element manufacturing process of forming an insulating layer, a semiconductor layer, and a conductive layer by coating, deposition, or the like and forming a semiconductor pattern, a conductive pattern, and a signal line by selectively making the insulating layer, the semiconductor layer, and the conductive layer subject to patterning by photolithography and etching processes.

The first to third anodes AE1, AE2, and AE3 and the first to third preliminary sacrificial patterns SP1-I, SP2-I, and SP3-I may be formed by the same patterning process. The preliminary pixel defining layer PDL-I may be disposed over the base layer BL and may cover the first to third anodes AE1, AE2, and AE3 and the first to third preliminary sacrificial patterns SP1-I, SP2-I, and SP3-I.

The preliminary barrier wall PW-I may include a first preliminary layer L1-I and a second preliminary layer L2-I disposed on the first preliminary layer L1-I. The first preliminary layer L1-I may have a first conductivity and a first thickness, and the second preliminary layer L2-I may have a second conductivity lower than the first conductivity and a second thickness smaller than the first thickness.

An initial photoresist layer PR may be formed by forming a preliminary photoresist layer on the preliminary barrier wall PW-I and thereafter making the preliminary photoresist layer subject to patterning by a photo mask. First to third openings OP1, OP2, and OP3 that overlap the first to third anodes AE1, AE2, and AE3 and recess openings OPH may be defined in the initial photoresist layer PR through a patterning process. The recess openings OPH may be defined between the first to third openings OP1, OP2, and OP3. In an embodiment, the recess openings OPH may be defined between the first opening OP1 and the second opening OP2 and between the second opening OP2 and the third opening OP3, for example.

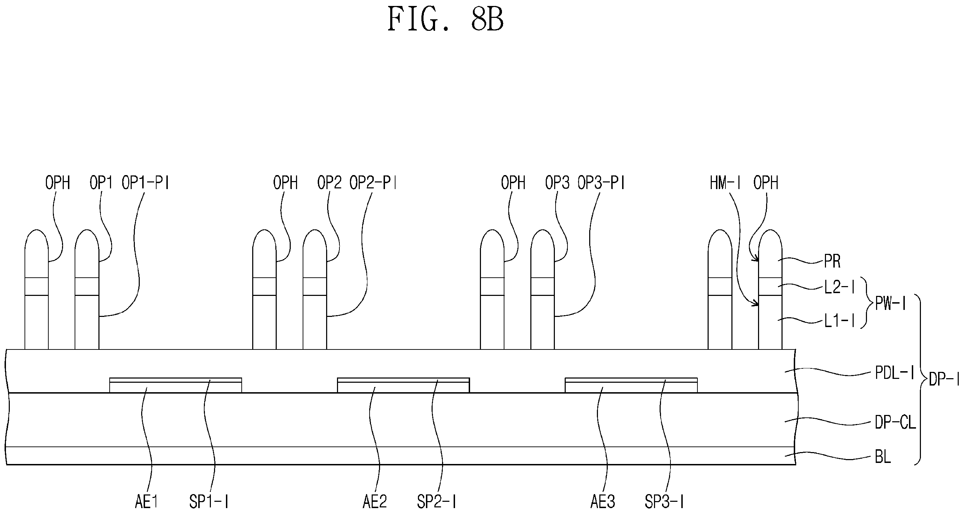

Referring to FIGS. 8B and 8C, the first group process may include an operation of forming the barrier wall PW having first to third preliminary barrier openings OP1-PI, OP2-PI, and OP3-PI and preliminary recesses HM-I defined therein from the preliminary barrier wall PW-I through a first etching process.

As illustrated in FIG. 8B, the first etching process may dry etch the first preliminary layer L1-I and the second preliminary layer L2-I by the initial photoresist layer PR as a mask. As a result of the dry etching, the first to third preliminary barrier openings OP1-PI, OP2-PI, and OP3-PI and the preliminary recesses HM-I may be defined in the preliminary barrier wall PW-I. Specifically, the first to third preliminary barrier openings OP1-PI, OP2-PI, and OP3-PI may be formed by the first to third openings OP1, OP2, and OP3 of the initial photoresist layer PR, and the preliminary recesses HM-I may be formed by the recess opening OPH of the initial photoresist layer PR. That is, the preliminary recesses HM-I may be defined between the first preliminary barrier opening OP1-PI and the second preliminary barrier opening OP2-PI and between the second preliminary barrier opening OP2-PI and the third preliminary barrier opening OP3-PI.

The dry etching in the first etching process may be performed in an etching environment in which the etch selectivity between the first preliminary layer L1-I and the second preliminary layer L2-I is substantially the same. Accordingly, an inner surface of the first preliminary layer L1-I and an inner surface of the second preliminary layer L2-I that define the first to third preliminary barrier openings OP1-PI, OP2-PI, and OP3-PI and the preliminary recesses HM-I may be substantially aligned with each other.

As illustrated in FIG. 8C, the first etching process may wet etch the first preliminary layer L1-I and the second preliminary layer L2-I by the initial photoresist layer PR as a mask. As a result of the wet etching, the first to third barrier openings OP1-P, OP2-P, and OP3-P may be formed from the first to third preliminary barrier openings OP1-PI, OP2-PI, and OP3-PI, and the recesses HM may be formed from the preliminary recesses HM-I. The barrier wall PW that includes the first barrier wall portion PW1 defining the first barrier opening OP1-P, the second barrier wall portion PW2 defining the second barrier opening OP2-P, and the third barrier wall portion PW3 defining the third barrier opening OP3-P may be formed from the preliminary barrier wall PW-I. Furthermore, the barrier wall PW having the recesses HM defined between the first barrier wall portion PW1 and the second barrier wall portion PW2, between the second barrier wall portion PW2 and the third barrier wall portion PW3, and between the first barrier wall portion PW1 and the third barrier wall portion PW3 may be formed from the preliminary barrier wall PW-I.

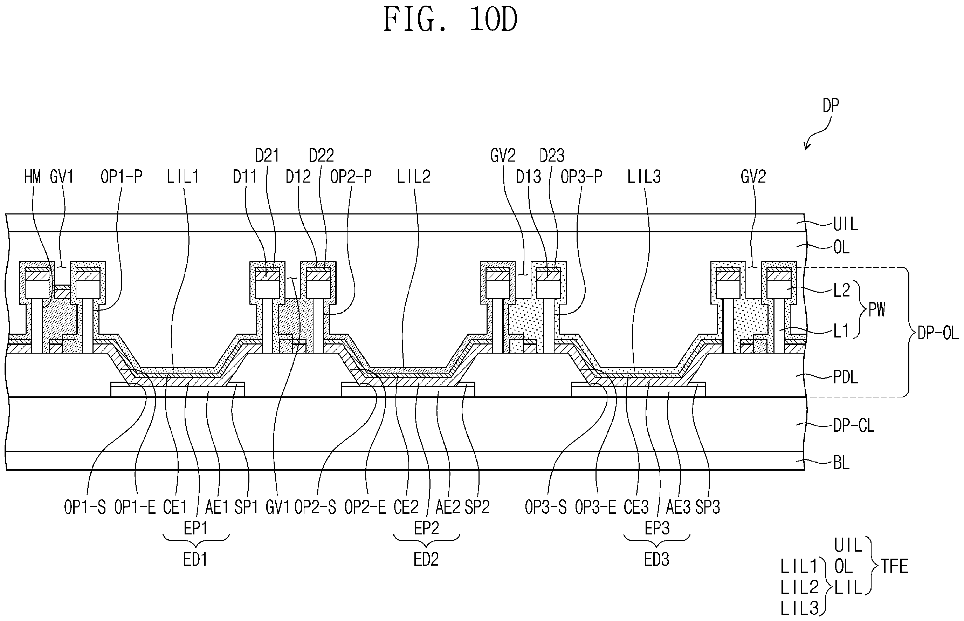

According to the disclosure, the first barrier wall portion PW1 defining the first barrier opening OP1-P, the second barrier wall portion PW2 defining the second barrier opening OP2-P, the third barrier wall portion PW3 defining the third barrier opening OP3-P, and the recesses HM may be simultaneously formed by the same process using the initial photoresist layer PR as a mask. Accordingly, the number of masks desired for forming the display panel DP (refer to FIG. 10D) may be decreased.

The first barrier opening OP1-P may be formed to overlap the first anode AE1, the second barrier opening OP2-P may be formed to overlap the second anode AE2, and the third barrier opening OP3-P may be formed to overlap the third anode AE3. That is, the recesses HM may be defined between the first barrier opening OP1-P and the second barrier opening OP2-P and between the second barrier opening OP2-P and the third barrier opening OP3-P.

The first to third barrier openings OP1-P, OP2-P, and OP3-P and the recesses HM may include the first region A1 defined by the inner surface of the first layer L1 and the second region A2 defined by the inner surface of the second layer L2.

The wet etching in the first etching process may be performed in an environment in which the etch selectivity between the first layer L1 and the second layer L2 is large. Accordingly, the barrier wall PW that defines the first to third barrier openings OP1-P, OP2-P, and OP3-P and the recesses HM may have an undercut shape on the section. Specifically, the first layer L1 may be mainly etched since the etch rate of the first layer L1 by an etching solution is greater than the etch rate of the second layer L2. Accordingly, the inner surface of the first layer L1 may be further recessed inward, compared to the inner surface of the second layer L2. The tip portion of the barrier wall PW may be formed by the portion of the second layer L2 that further protrudes beyond the first layer L1.

The first group process may include an operation of removing the initial photoresist layer PR.

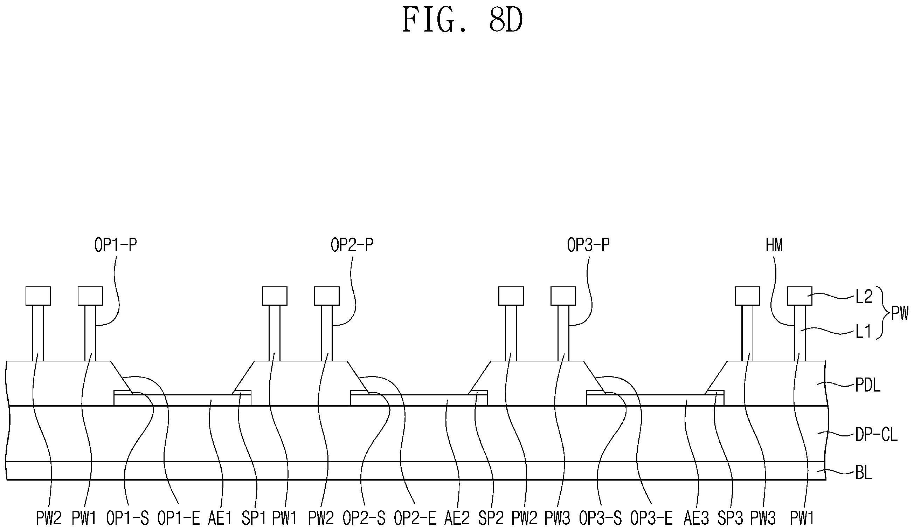

Referring to FIG. 8D, the first group process may include an operation of forming the pixel defining layer PDL having the first to third light-emitting openings OP1-E, OP2-E, and OP3-E defined therein from the preliminary pixel defining layer PDL-I (refer to FIG. 8C) through a second etching process. The second etching process may be performed by a dry etching method and may be performed by a mask different from the initial photoresist layer PR.

According to the disclosure, the first to third light-emitting openings OP1-E, OP2-E, and OP3-E of the pixel defining layer PDL may be simultaneously formed by the same process using one mask. Accordingly, the number of masks desired for forming the display panel DP (refer to FIG. 10D) may be decreased.

Furthermore, the first group process may include an operation of forming the first to third sacrificial patterns SP1, SP2 and SP3 having the first to third sacrificial openings OP1-S, OP2-S, and OP3-S defined therein from the first to third preliminary sacrificial patterns SP1-I, SP2-I, and SP3-I (refer to FIG. 8C) through a third etching process. Specifically, the first to third sacrificial openings OP1-S, OP2-S, and OP3-S may be defined in the first to third sacrificial patterns SP1, SP2 and SP3 to expose at least portions of the first to third anodes AE1, AE2, and AE3 (hereinafter, also referred to as the anodes). The third etching process of the first group process may be performed by a wet etching method and may be performed by the pixel defining layer PDL having the first to third light-emitting openings OP1-E, OP2-E, and OP3-E defined therein as a mask.

Although FIG. 8D illustrates one example that inner surfaces of the first to third sacrificial patterns SP1, SP2, and SP3 (hereinafter, also referred to as the sacrificial patterns) that define the first to third sacrificial openings OP1-S, OP2-S, and OP3-S and the inner surfaces of the pixel defining layer PDL that define the first to third light-emitting openings OP1-E, OP2-E, and OP3-E are aligned, the disclosure is not limited thereto. In an embodiment, the inner surfaces of the first to third sacrificial patterns SP1, SP2, and SP3 that define the first to third sacrificial openings OP1-S, OP2-S, and OP3-S may be recessed inward, compared to the inner surfaces of the pixel defining layer PDL that define the first to third light-emitting openings OP1-E, OP2-E, and OP3-E, for example.

The third etching process may be performed in an environment in which the etch selectivity between the first to third sacrificial patterns SP1, SP2, and SP3 and the first to third anodes AE1, AE2, and AE3 is large. Accordingly, the first to third anodes AE1, AE2, and AE3 may be prevented from being etched together. That is, the first to third sacrificial patterns SP1, SP2, and SP3 having a higher etch rate than the first to third anodes AE1, AE2, and AE3 may be disposed between the pixel defining layer PDL and the first to third anodes AE1, AE2, and AE3, and thus the first to third anodes AE1, AE2, and AE3 may be prevented from being etched and damaged together during the etching process. The third etching process may be performed as an etching process separate from the second etching process, or may be performed as an etching process the same as the second etching process.

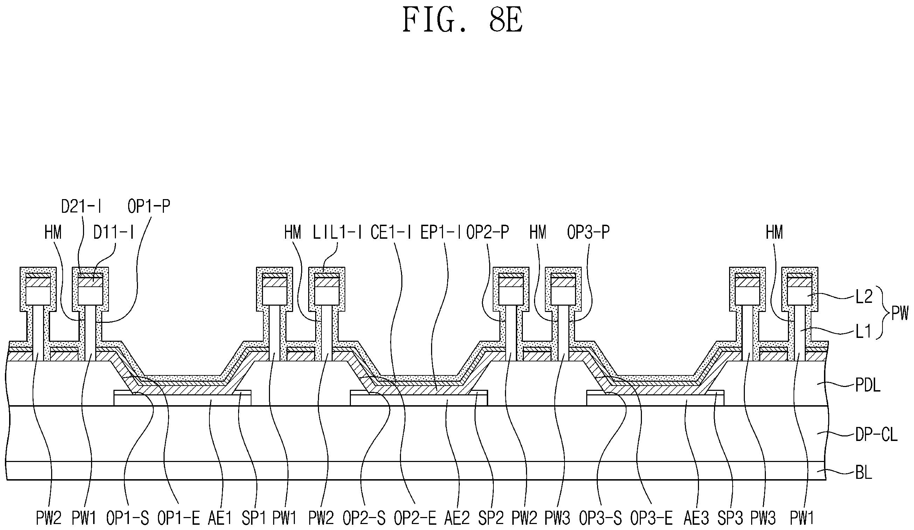

Referring to FIGS. 8E to 8G, the first group process may include an operation of forming the first emission pattern EP1 and the first cathode CE1 in the first light-emitting opening OP1-E and an operation of forming the first lower inorganic encapsulation pattern LII,1.

Referring to FIG. 8E, the first group process may include an operation of forming a first preliminary emission pattern EP1-I on the pixel defining layer PDL, an operation of forming a first preliminary cathode CE1-I on the first preliminary emission pattern EP1-I, and an operation of forming a first lower inorganic encapsulation film LII,1-I on the first preliminary cathode CE1-I.

In an embodiment, the first preliminary emission pattern EP1-I may be formed by a method of depositing a first organic material. In an embodiment, the first preliminary emission pattern EP1-I may be formed by a thermal evaporation process, for example, but is not limited thereto. The first preliminary cathode CE1-I may be formed by a method of depositing a first conductive material. In an embodiment, the first preliminary cathode CE1-I may be formed by a sputtering process, for example, but is not limited thereto.

The first preliminary emission pattern EP1-I may be separated by the tip portion formed on the barrier wall PW, may be disposed in the first to third light-emitting openings OP1-E, OP2-E, and OP3-E and the first to third barrier openings OP1-P, OP2-P, and OP3-P, and may be disposed in the recesses HM. The first preliminary cathode CE1-I may be separated by the tip portion formed on the barrier wall PW, may be disposed in the first to third light-emitting openings OP1-E, OP2-E, and OP3-E and the first to third barrier openings OP1-P, OP2-P, and OP3-P, and may be disposed in the recesses HM.

In the operation of forming the first preliminary emission pattern EP1-I, a 1-1 dummy layer D1 1-I may be formed on the barrier wall PW together, and in the operation of forming the first preliminary cathode CE1-I, a 2-1 dummy layer D21-I may be formed on the barrier wall PW together.

In an embodiment, the first lower inorganic encapsulation film LIL1-I may be formed through a chemical vapor deposition ("CVD") process. The first lower inorganic encapsulation film LIL1-I may be formed on the barrier wall PW and the first preliminary cathode CE1-I, and a portion of the first lower inorganic encapsulation film LIL1-I may be formed in the first to third barrier openings OP1-P, OP2-P, and OP3-P and the recesses HM.

The display panel manufacturing method according to the disclosure may further include an operation of forming a first preliminary capping pattern between the operation of forming the first preliminary cathode CE1-I and the operation of forming the first lower inorganic encapsulation film LIL1-I. The first preliminary capping pattern may be formed through a deposition process. The first preliminary capping pattern may be separated by the tip portion formed on the barrier wall PW and may be disposed in the first to third light-emitting openings OP1-E, OP2-E, and OP3-E and the first to third barrier openings OP1-P, OP2-P, and OP3-P. Furthermore, in the operation of forming the first preliminary capping pattern, a 3-1 dummy layer may be formed on the 2-1 dummy layer D21-I together.

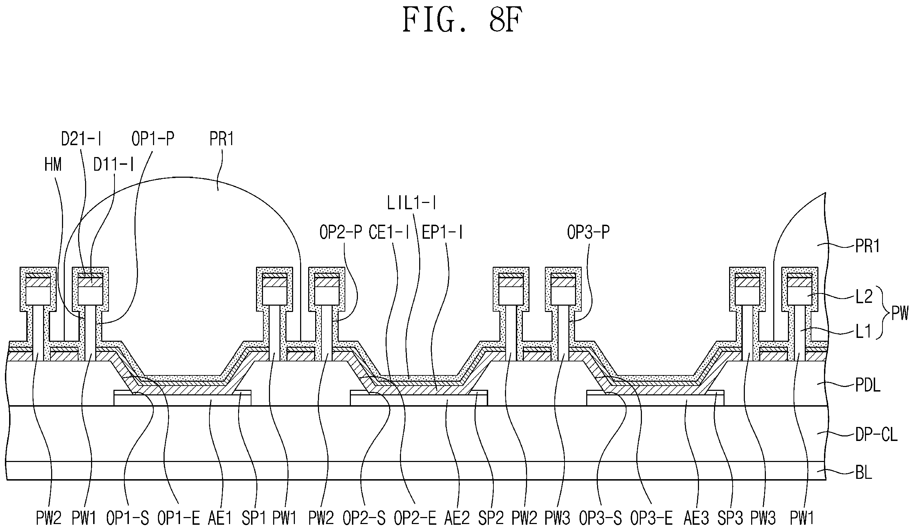

Referring to FIG. 8F, the first group process may include an operation of forming a first photoresist layer PR1. The first photoresist layer PR1 may be formed by forming a preliminary photoresist layer on the first lower inorganic encapsulation film LIL1-I and making the preliminary photoresist layer subject to patterning by a photo mask. Through the patterning process, the first photoresist layer PR1 may be formed in a pattern form corresponding to the first light-emitting opening OP1-E. Specifically, an edge of the first photoresist layer PR1 may be formed to overlap the recesses HM adjacent to the first light-emitting opening OP1-E.

Referring to FIGS. 8F and 8G, the first group process may include an operation of forming the first emission pattern EP1, the first cathode CE1, and the first lower inorganic encapsulation pattern LIL1 through a fourth etching process.

The fourth etching process may dry etch the first preliminary emission pattern EP1-I, the first preliminary cathode CE1-I, and the first lower inorganic encapsulation film LIL1-I by the first photoresist layer PR1 as a mask. As a result of the dry etching, portions of the first preliminary emission pattern EP1-I, the first preliminary cathode CE1-I, and the first lower inorganic encapsulation film LIL1-I that overlap the second anode AE2 and the third anode AE3 may be removed. The first emission pattern EP1, the first cathode CE1, and the first lower inorganic encapsulation pattern LIL1 that overlap the first light-emitting opening OP1-E may be formed from the first preliminary emission pattern EP1-I, the first preliminary cathode CE1-I, and the first lower inorganic encapsulation film LIL1-I from which the portions overlapping the second anode AE2 and the third anode AE3 are removed.

One portion of the first lower inorganic encapsulation pattern LIL1 may be disposed in the first barrier opening OP1-P and may cover the first light-emitting element ED1, and another portion of the first lower inorganic encapsulation pattern LIL1 may be disposed on the first barrier wall portion PW1. Specifically, the first lower inorganic encapsulation pattern LIL1 may be disposed on the 2-1 dummy pattern D21. The remaining portion of the first lower inorganic encapsulation pattern LIL1 may be disposed in the recesses HM along the side surface of the first barrier wall portion PW1 and may cover the first barrier wall portion PW1. That is, at least a portion of the first lower inorganic encapsulation pattern LIL1 may be accommodated in the recesses HM.

According to the disclosure, a portion of the first preliminary emission pattern EP1-I (hereinafter, also referred to as the first sacrificial emission pattern) may be separately formed in the recesses HM between the first barrier wall portion PW1 and the second barrier wall portion PW2, and the first lower inorganic encapsulation pattern LIL1 may be formed on the first sacrificial emission pattern EP1-I in the recesses HM. Even though the first sacrificial emission pattern EP1-I is lost in an etching process, since the first lower inorganic encapsulation pattern LIL1 disposed in the recesses HM between the first barrier wall portion PW1 and the second barrier wall portion PW2 is fixed by the tip portion of the barrier wall PW, the shape of the thin film encapsulation layer TFE (refer to FIG. 10D) may be maintained. Accordingly, oxidation of the first cathode CE1 may be prevented by blocking a moisture permeation path into the first light-emitting element ED1, and thus the reliability of the display device DD (refer to FIG. 1A) may be improved.

The first preliminary emission pattern EP1-I and the first preliminary cathode CE1-I formed in the recesses HM may be lost. Specifically, the first preliminary emission pattern EP1-I and the first preliminary cathode CE1-I formed in the recesses HM between the first barrier wall portion PW1 and the second barrier wall portion PW2 may be lost. As a result, the first space BS1 may be formed under the first lower inorganic encapsulation pattern LIL1 that covers the lost first preliminary emission pattern EP1-I and the lost first preliminary cathode CE1-I. The first space BS1 may be a space between one portion of the first lower inorganic encapsulation pattern LIL1 and the pixel defining layer PDL in the recesses HM.

Furthermore, the fourth etching process of the display panel manufacturing method of the disclosure may remove portions of the 1-1 dummy layer D11-I and the 2-1 dummy layer D21-I that overlap the second anode AE2 and the third anode AE3, by dry etching the 1-1 dummy layer D11-I and the 2-1 dummy layer D21-I using the first photoresist layer PR1 as a mask. The 1-1 dummy pattern D11 and the 2-1 dummy pattern D21 having a closed-line shape surrounding the first emissive region PXA-R in the plan view may be formed from the 1-1 dummy layer D11-I and the 2-1 dummy layer D21-I from which the portions overlapping the second anode AE2 and the third anode AE3 are removed. However, without being limited thereto, the first emission pattern EP1, the first cathode CE1, the first lower inorganic encapsulation pattern LIL1, the 1-1 dummy pattern D11, and the 2-1 dummy pattern D21 may be formed through separate processes.

In a case in which the display panel manufacturing method in an embodiment further includes an operation of forming a first capping pattern, portions of the 3-1 dummy layer that overlap the second anode AE2 and the third anode AE3 may be removed by etching the 3-1 dummy layer together in the fourth etching process, and thus a 3-1 dummy pattern may be formed.

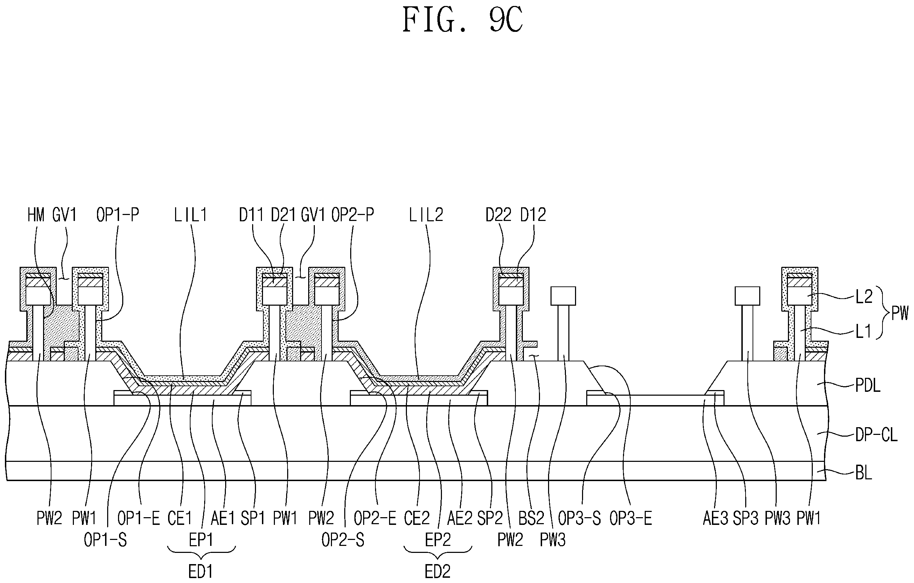

The second group process may be performed after the first group process. In this embodiment, the second light-emitting element ED2 (refer to FIG. 9C) and the second lower inorganic encapsulation pattern LIL2 (refer to FIG. 9C) that covers the second light-emitting element ED2 may be formed through the second group process. Hereinafter, the second group process will be described with reference to FIGS. 9A to 9C.

Referring to FIGS. 9A to 9C, the second group process may include an operation of forming a second preliminary emission pattern EP2-I on the first lower inorganic encapsulation pattern LIL1 and the pixel defining layer PDL, an operation of forming a second preliminary cathode CE2-I on the second preliminary emission pattern EP2-I, and an operation of forming a second lower inorganic encapsulation film LIL2-I on the second preliminary cathode CE2-I.

Referring to FIG. 9A, the operation of forming the second preliminary emission pattern EP2-I may be performed in a manner similar to the operation of forming the first preliminary emission pattern EP1-I in the first group process (refer to FIG. 8E). In an embodiment, the second preliminary emission pattern EP2-I may be formed by a method of depositing a second organic material on the first lower inorganic encapsulation pattern LIL1 and the pixel defining layer PDL, for example. The second organic material may include a material that is the same as or different from the first organic material.

The operation of forming the second preliminary cathode CE2-I may be performed in a manner similar to the operation of forming the first preliminary cathode CE1-I in the first group process (refer to FIG. 8E). In an embodiment, the second preliminary cathode CE2-I may be formed by a method of depositing the first conductive material on the second preliminary emission pattern EP2-I, for example.

The operation of forming the second lower inorganic encapsulation film LIL2-I may be performed in a manner similar to the operation of forming the first lower inorganic encapsulation film LIL1-I in the first group process (refer to FIG. 8E). The second lower inorganic encapsulation film LIL2-I may be formed on the second preliminary cathode CE2-I, and a portion of the second lower inorganic encapsulation film LIL2-I may be formed in the first to third barrier openings OP1-P, OP2-P, and OP3-P and the recesses HM. A portion of the second lower inorganic encapsulation film LIL2-I may fill the first space BS1 formed when the first lower inorganic encapsulation pattern LIL1 is etched.

In the operation of forming the second preliminary emission pattern EP2-I, a 1-2 dummy layer D12-I spaced apart from the second preliminary emission pattern EP2-I may be formed on the barrier wall PW together. In the operation of forming the second preliminary cathode CE2-I, a 2-2 dummy layer D22-I spaced apart from the second preliminary cathode CE2-I may be formed on the barrier wall PW together.

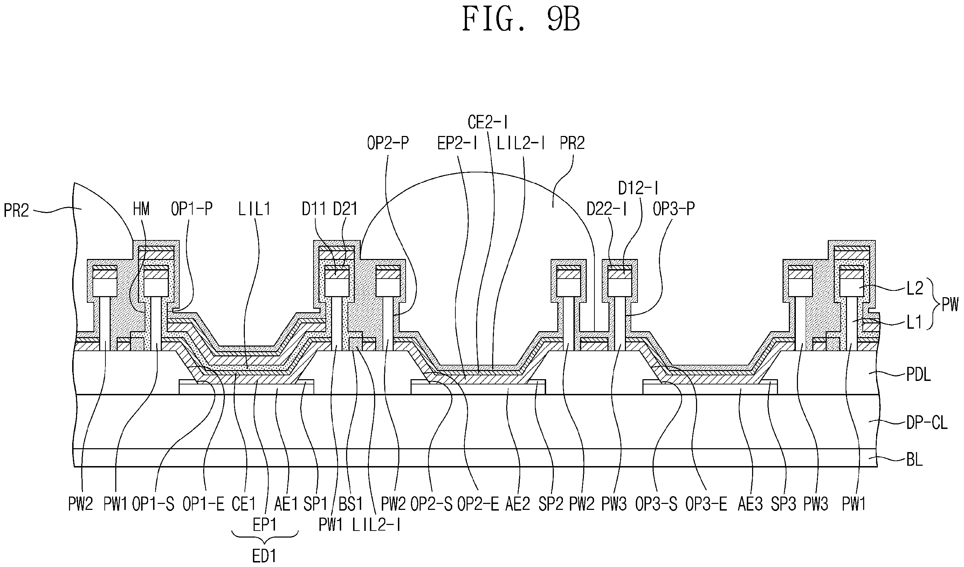

Referring to FIG. 9B, the second group process may include an operation of forming a second photoresist layer PR2. The second photoresist layer PR2 may be formed by forming a preliminary photoresist layer on the second lower inorganic encapsulation film LIL2-I and making the preliminary photoresist layer subject to patterning by a photo mask. Through the patterning process, the second photoresist layer PR2 may be formed in a pattern form corresponding to the second light-emitting opening OP2-E. Specifically, an edge of the second photoresist layer PR2 may be formed to overlap the recesses HM adjacent to the second light-emitting opening OP2-E.

Referring to FIGS. 9B and 9C, the second group process may include an operation of forming the second emission pattern EP2, the second cathode CE2, and the second lower inorganic encapsulation pattern LIL2 through a fifth etching process.

The fifth etching process may dry etch the second preliminary emission pattern EP2-I, the second preliminary cathode CE2-I, and the second lower inorganic encapsulation film LIL2-I by the second photoresist layer PR2 as a mask. As a result of the dry etching, portions of the second preliminary emission pattern EP2-I, the second preliminary cathode CE2-I, and the second lower inorganic encapsulation film LIL2-I that overlap the first anode AE1 and the third anode AE3 may be removed. The second emission pattern EP2, the second cathode CE2, and the second lower inorganic encapsulation pattern LIL2 that overlap the second light-emitting opening OP2-E may be formed from the second preliminary emission pattern EP2-I, the second preliminary cathode CE2-I, and the second lower inorganic encapsulation film LIL2-I from which the portions overlapping the first anode AE1 and the third anode AE3 are removed.

One portion of the second lower inorganic encapsulation pattern LIL2 may be disposed in the second barrier opening OP2-P and may cover the second light-emitting element ED2, and another portion of the second lower inorganic encapsulation pattern LIL2 may be disposed on the second barrier wall portion PW2. Specifically, the second lower inorganic encapsulation pattern LIL2 may be disposed on the 2-2 dummy pattern D22. The remaining portion of the second lower inorganic encapsulation pattern LIL2 may be disposed in the recesses HM along the side surface of the second barrier wall portion PW2 and may cover a portion of the first lower inorganic encapsulation pattern LIL1, the second emission pattern EP2, and the second cathode CE2. That is, at least a portion of the second lower inorganic encapsulation pattern LIL2 may be accommodated in the recesses HM.

The operation of forming the second lower inorganic encapsulation pattern LIL2 may include an operation of defining the first groove GV1 in the regions of the first lower inorganic encapsulation pattern LIL1 and the second lower inorganic encapsulation pattern LIL2 that overlap the recesses HM. As a result of etching the second photoresist layer PR2 as a mask, the first groove GV1 may be defined in the thickness direction of the barrier wall PW in the regions of the first lower inorganic encapsulation pattern LIL1 and the second lower inorganic encapsulation pattern LIL2 that overlap the recesses HM. That is, one portion of the side surface that defines the first groove GV1 may be defined by the first lower inorganic encapsulation pattern LII,1, and another portion of the side surface may be defined by the second lower inorganic encapsulation pattern LIL2.

According to the disclosure, a portion of the second preliminary emission pattern EP2-I (hereinafter, also referred to as the second sacrificial emission pattern) may be separately formed in the recesses HM between the second barrier wall portion PW2 and the third barrier wall portion PW3, and the second lower inorganic encapsulation pattern LIL2 may be formed on the second sacrificial emission pattern EP2-I in the recesses HM. Even though the second sacrificial emission pattern EP2-I is lost in an etching process, since a portion of the second lower inorganic encapsulation pattern LIL2 disposed in the recesses HM between the second barrier wall portion PW2 and the third barrier wall portion PW3 is fixed by the tip portion of the barrier wall PW, the shape of the thin film encapsulation layer TFE (refer to FIG. 10D) may be maintained. Accordingly, oxidation of the second cathode CE2 may be prevented by blocking a moisture permeation path into the second light-emitting element ED2, and thus the reliability of the display device DD (refer to FIG. 1A) may be improved.

The second preliminary emission pattern EP2-I and the second preliminary cathode CE2-I formed in the recesses HM may be lost. Specifically, the second preliminary emission pattern EP2-I and the second preliminary cathode CE2-I formed in the recesses HM between the second light-emitting opening OP2-E and the third light-emitting opening OP3-E may be lost. As a result, the second space BS2 may be formed under the second lower inorganic encapsulation pattern LIL2 that covers the lost second preliminary emission pattern EP2-I and the lost second preliminary cathode CE2-I. The second space BS2 may be a space between one portion of the second lower inorganic encapsulation pattern LIL2 and the pixel defining layer PDL in the recesses HM.

Furthermore, the fifth etching process of the display panel manufacturing method of the disclosure may remove portions of the 1-2 dummy layer D12-I and the 2-2 dummy layer D22-I that overlap the first anode AE1 and the third anode AE3, by dry etching the 1-2 dummy layer D12-I and the 2-2 dummy layer D22-I using the second photoresist layer PR2 as a mask. The 1-2 dummy pattern D12 and the 2-2 dummy pattern D22 having a closed-line shape surrounding the second emissive region PXA-G in the plan view may be formed from the 1-2 dummy layer D12-I and the 2-2 dummy layer D22-I from which the portions overlapping the first anode AE1 and the third anode AE3 are removed. However, without being limited thereto, the second emission pattern EP2, the second cathode CE2, the second lower inorganic encapsulation pattern LIL2, the 1-2 dummy pattern D12, and the 2-2 dummy pattern D22 may be formed through separate processes.

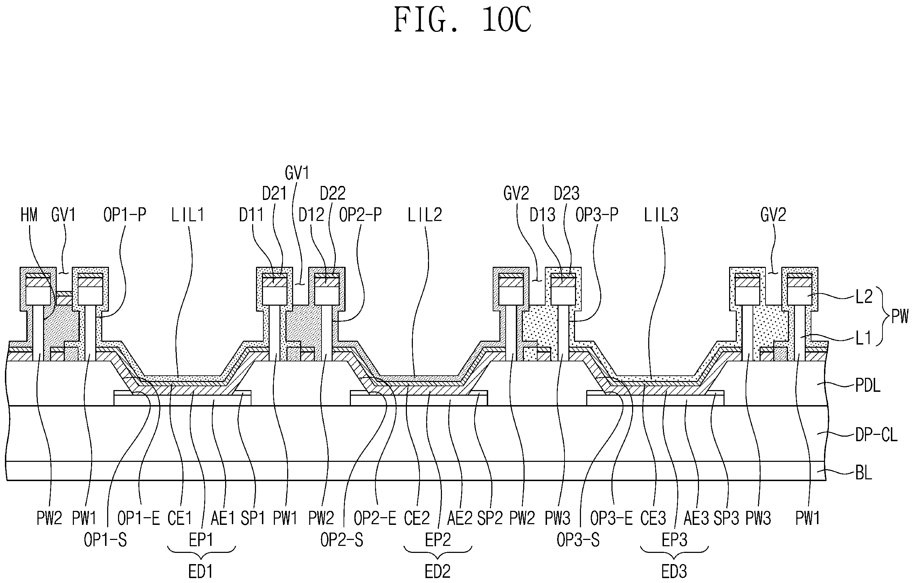

The third group process may be performed after the second group process. In this embodiment, the third light-emitting element ED3 (refer to FIG. 10C) and the third lower inorganic encapsulation pattern LIL3 (refer to FIG. 10C) that covers the third light-emitting element ED3 may be formed through the third group process. Hereinafter, the third group process will be described with reference to FIGS. 10A to 10C.

Referring to FIGS. 10A to 10C, the third group process may include an operation of forming a third preliminary emission pattern EP3-I on the first lower inorganic encapsulation pattern LIL1, the second lower inorganic encapsulation pattern LIL2, and the pixel defining layer PDL, an operation of forming a third preliminary cathode CE3-I on the third preliminary emission pattern EP3-I, and an operation of forming a third lower inorganic encapsulation film LIL3-I on the third preliminary cathode CE3-I.

Referring to FIG. 10A, the operation of forming the third preliminary emission pattern EP3-I may be performed in a manner similar to the operation of forming the first preliminary emission pattern EP1-I in the first group process (refer to FIG. 8E). In an embodiment, the third preliminary emission pattern EP3-I may be formed by a method of depositing a third organic material on the first lower inorganic encapsulation pattern LIL1, the second lower inorganic encapsulation pattern LIL2, and the pixel defining layer PDL, for example. The third organic material may include a material that is the same as or different from the first organic material and/or the second organic material.

The operation of forming the third preliminary cathode CE3-I may be performed in a manner similar to the operation of forming the first preliminary cathode CE1-I in the first group process (refer to FIG. 8E). In an embodiment, the third preliminary cathode CE3-I may be formed by a method of depositing the first conductive material on the third preliminary emission pattern EP3-I, for example.

The operation of forming the third lower inorganic encapsulation film LIL3-I may be performed in a manner similar to the operation of forming the first lower inorganic encapsulation film LIL1-I in the first group process (refer to FIG. 8E). The third lower inorganic encapsulation film LIL3-I may be formed on the third preliminary cathode CE3-I, and a portion of the third lower inorganic encapsulation film LIL3-I may be formed in the first to third barrier openings OP1-P, OP2-P, and OP3-P and the recesses HM. A portion of the third lower inorganic encapsulation film LIL3-I may fill the second space BS2 formed when the second lower inorganic encapsulation pattern LIL2 is etched.

In the operation of forming the third preliminary emission pattern EP3-I, a 1-3 dummy layer D13-I spaced apart from the third preliminary emission pattern EP3-I may be formed on the barrier wall PW together. In the operation of forming the third preliminary cathode CE3-I, a 2-3 dummy layer D23-I spaced apart from the third preliminary cathode CE3-I may be formed on the barrier wall PW together.

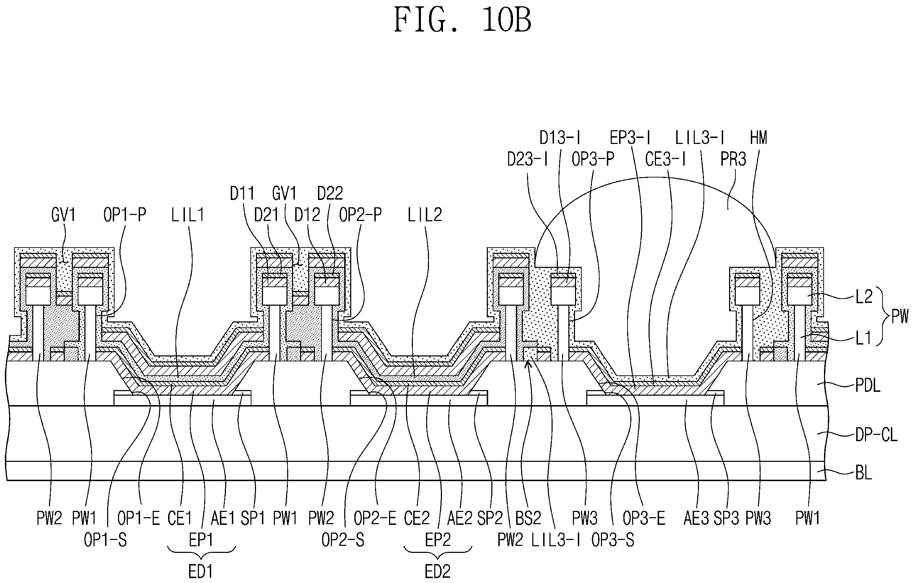

Referring to FIG. 10B, the third group process may include an operation of forming a third photoresist layer PR3. The third photoresist layer PR3 may be formed by forming a preliminary photoresist layer on the third lower inorganic encapsulation film LIL3-I and making the preliminary photoresist layer subject to patterning by a photo mask. Through the patterning process, the third photoresist layer PR3 may be formed in a pattern form corresponding to the third light-emitting opening OP3-E. Specifically, an edge of the third photoresist layer PR3 may be formed to overlap the recesses HM adjacent to the third light-emitting opening OP3-E.

Referring to FIGS. 10B and 10C, the third group process may include an operation of forming the third emission pattern EP3, the third cathode CE3, and the third lower inorganic encapsulation pattern LIL3 through a sixth etching process.

The sixth etching process may dry etch the third preliminary emission pattern EP3-I, the third preliminary cathode CE3-I, and the third lower inorganic encapsulation film LIL3-I by the third photoresist layer PR3 as a mask. As a result of the dry etching, portions of the third preliminary emission pattern EP3-I, the third preliminary cathode CE3-I, and the third lower inorganic encapsulation film LIL3-I that overlap the first anode AE1 and the second anode AE2 may be removed. The third emission pattern EP3, the third cathode CE3, and the third lower inorganic encapsulation pattern LIL3 that overlap the third light-emitting opening OP3-E may be formed from the third preliminary emission pattern EP3-I, the third preliminary cathode CE3-I, and the third lower inorganic encapsulation film LIL3-I from which the portions overlapping the first anode AE1 and the second anode AE2 are removed.

One portion of the third lower inorganic encapsulation pattern LIL3 may be disposed in the third barrier opening OP3-P and may cover the third light-emitting element ED3, and another portion of the third lower inorganic encapsulation pattern LIL3 may be disposed in the recesses HM along the upper surface of the barrier wall PW and may cover the third barrier wall portion PW3. That is, at least a portion of the third lower inorganic encapsulation pattern LIL3 may be accommodated in the recesses HM.

The operation of forming the third lower inorganic encapsulation pattern LIL3 may include an operation of defining the second groove GV2. The second groove GV2 may be defined in the thickness direction of the barrier wall PW in the regions of the first lower inorganic encapsulation pattern LIL1 and the third lower inorganic encapsulation pattern LIL3 that overlap the recesses HM and in the regions of the second lower inorganic encapsulation pattern LIL2 and the third lower inorganic encapsulation pattern LIL3 that overlap the recesses HM. This is a result obtained by etching the third lower inorganic encapsulation film LIL3-I using the third photoresist layer PR3 as a mask. One portion of the side surface that defines the second groove GV2 may be defined by the first lower inorganic encapsulation pattern LIL1 or the second lower inorganic encapsulation pattern LIL2, and another portion of the side surface may be defined by the third lower inorganic encapsulation pattern LIL3.

Furthermore, the sixth etching process of the display panel manufacturing method of the disclosure may remove portions of the 1-3 dummy layer D13-I and the 2-3 dummy layer D23-I that overlap the first anode AE1 and the second anode AE2, by dry etching the 1-3 dummy layer D13-I and the 2-3 dummy layer D23-I using the third photoresist layer PR3 as a mask. The 1-3 dummy pattern D13 and the 2-3 dummy pattern D23 having a closed-line shape surrounding the third emissive region PXA-B in the plan view may be formed from the 1-3 dummy layer D13-I and the 2-3 dummy layer D23-I from which the portions overlapping the first anode AE1 and the second anode AE2 are removed. However, without being limited thereto, the third emission pattern EP3, the third cathode CE3, the third lower inorganic encapsulation pattern LIL3, the 1-3 dummy pattern D13, and the 2-3 dummy pattern D23 may be formed through separate processes.

The first to third light-emitting elements ED1, ED2, and ED3 and the first to third lower inorganic encapsulation patterns LIL1, LIL2, and LIL3 may be formed through the first to third group processes. The display panel DP including the thin film encapsulation layer TFE may be completed through the fourth group process after the third group process.

Referring to FIG. 10D, the fourth group process may include an operation of forming the organic encapsulation film OL on the first to third lower inorganic encapsulation patterns LIL1, LIL2, and LIL3 and an operation of forming the upper inorganic encapsulation film UIL on the organic encapsulation film OL. The first to third lower inorganic encapsulation patterns LIL1, LIL2, and LIL3, the organic encapsulation film OL, and the upper inorganic encapsulation film UIL may be also referred to as the thin film encapsulation layer TFE. Accordingly, the display panel DP including the base layer BL, the circuit element layer DP-CL, the display element layer DP-OL, and the thin film encapsulation layer TFE may be formed.

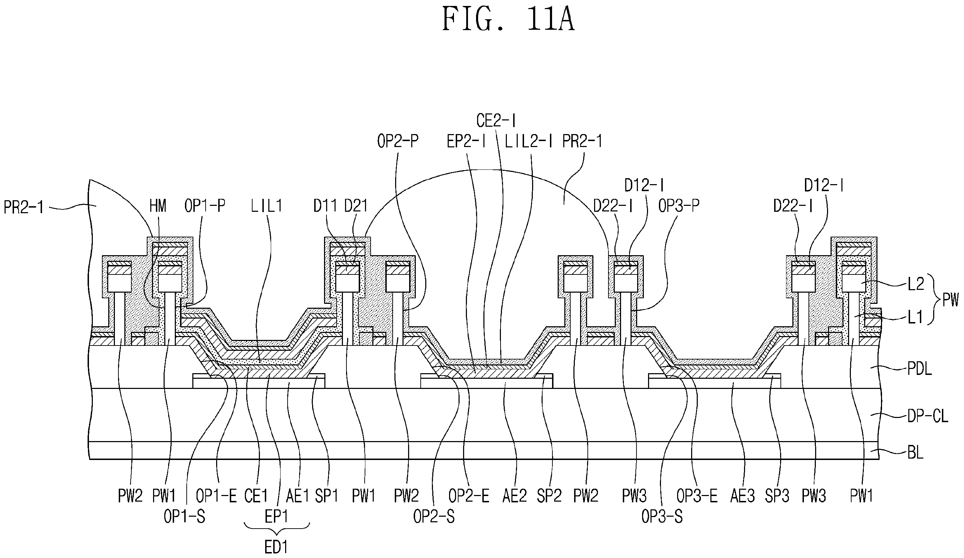

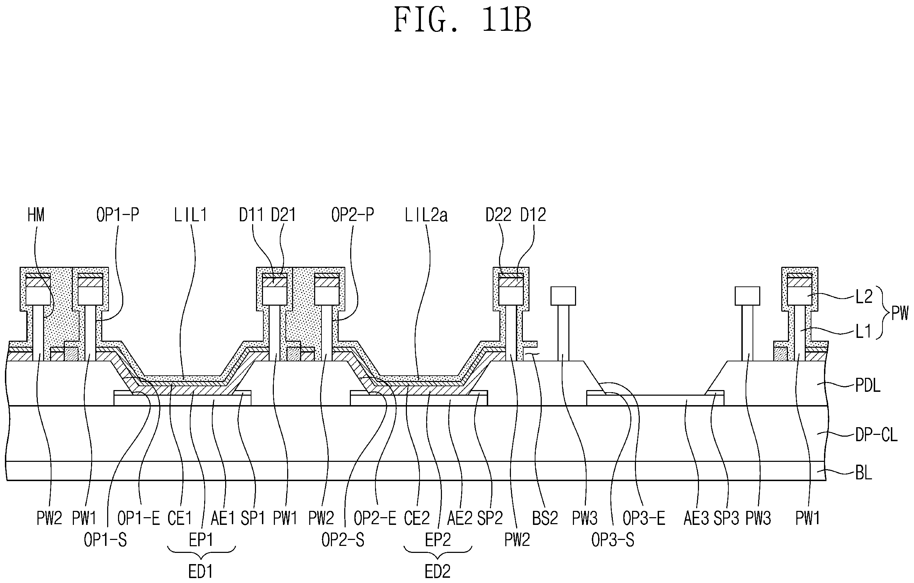

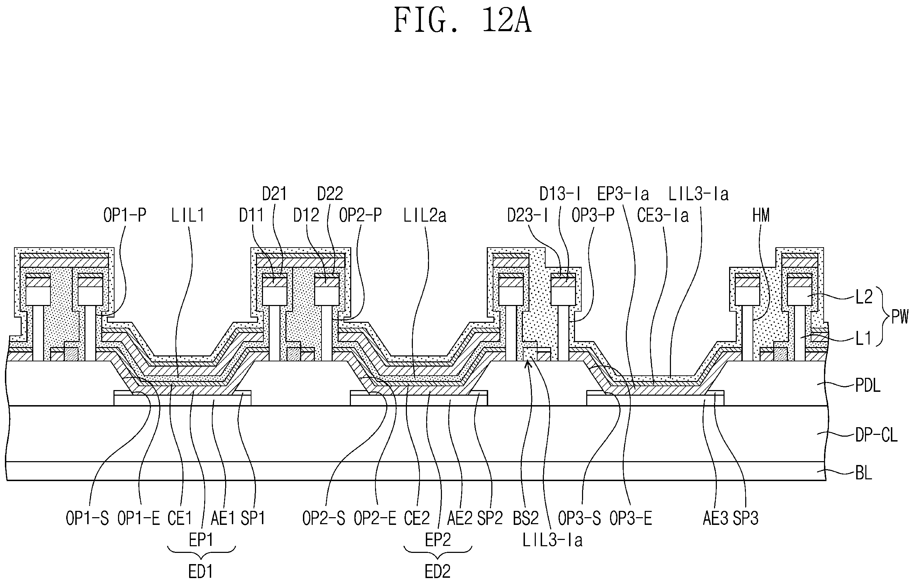

FIGS. 11A and 11B are cross-sectional views illustrating an embodiment of some of the operations of the display panel manufacturing method according to the disclosure. FIGS. 12A to 12D are cross-sectional views illustrating an embodiment of some of the operations of the display panel manufacturing method according to the disclosure. FIGS. 11A and 11B illustrate an embodiment of the second group process of the display panel manufacturing method, and FIGS. 12A to 12D illustrate an embodiment of the third group process and the fourth group process. In describing FIGS. 11A to 12D, the description will be made with reference to FIGS. 9A to 10D, and descriptions of the same reference numerals will be omitted.

A difference from the embodiment of the second group process described above with reference to FIGS. 9B and 9C will be described with reference to FIGS. 11A and 11B.

The second group process according to this embodiment may include an operation of forming a second photoresist layer PR2-1. The second photoresist layer PR2-1 may be formed by forming a preliminary photoresist layer on the second lower inorganic encapsulation film LIL2-I and making the preliminary photoresist layer subject to patterning by a photo mask. Through the patterning process, the second photoresist layer PR2-1 may be formed in a pattern form corresponding to the second light-emitting opening OP2-E. Specifically, an edge of the second photoresist layer PR2-1 may be formed so as not to overlap the recesses HM adjacent to the second light-emitting opening OP2-E.

Referring to FIGS. 11A and 11B, the second group process may include an operation of forming the second emission pattern EP2, the second cathode CE2, and the second lower inorganic encapsulation pattern LIL2a through the fifth etching process.

The fifth etching process may dry etch the second preliminary emission pattern EP2-I, the second preliminary cathode CE2-I, and the second lower inorganic encapsulation film LIL2-I by the second photoresist layer PR2-1 as a mask. The second emission pattern EP2, the second cathode CE2, and the second lower inorganic encapsulation pattern LIL2a that overlap the second light-emitting opening OP2-E may be formed from the second preliminary emission pattern EP2-I, the second preliminary cathode CE2-I, and the second lower inorganic encapsulation film LIL2-I from which the portions overlapping the first anode AE1 and the third anode AE3 are removed.

One portion of the second lower inorganic encapsulation pattern LIL2a may be disposed in the second barrier opening OP2-P and may cover the second light-emitting element ED2, and another portion of the second lower inorganic encapsulation pattern LIL2a may be disposed in the recesses HM along the upper surface of the barrier wall PW. That is, at least a portion of the second lower inorganic encapsulation pattern LIL2a may be accommodated in the recesses HM. As a result of etching the second lower inorganic encapsulation film LIL2-I using the second photoresist layer PR2-1 as a mask, the second lower inorganic encapsulation film LIL2-I may be etched in regions overlapping the recesses HM such that the upper surface of the first lower inorganic encapsulation pattern LIL1 and the upper surface of the second lower inorganic encapsulation pattern LIL2a are aligned.

A difference from the embodiment of the third group process described above with reference to FIGS. 10A to 10C will be described with reference to FIGS. 12A to 12C.

Referring to FIGS. 12A to 12C, the third group process may include an operation of forming a third preliminary emission pattern EP3-Ia on the first lower inorganic encapsulation pattern LIL1, the second lower inorganic encapsulation pattern LIL2a, and the pixel defining layer PDL, an operation of forming a third preliminary cathode CE3-Ia on the third preliminary emission pattern EP3-Ia, and an operation of forming a third lower inorganic encapsulation film LIL3-Ia on the third preliminary cathode CE3-Ia.

Referring to FIG. 12A, the operations of forming the third preliminary emission pattern EP3-Ia, the third preliminary cathode CE3-Ia, and the third lower inorganic encapsulation film LIL3-Ia may be performed in a manner similar to the operations of forming the third preliminary emission pattern EP3-I, the third preliminary cathode CE3-I, and the third lower inorganic encapsulation film LIL3-I of FIG. 10A.

The third preliminary emission pattern EP3-Ia and the third preliminary cathode CE3-Ia may be sequentially formed on the first lower inorganic encapsulation pattern LIL1, the second lower inorganic encapsulation pattern LIL2a, and the pixel defining layer PDL.

The third lower inorganic encapsulation film LIL3-Ia may be formed on the third preliminary cathode CE3-Ia, and a portion of the third lower inorganic encapsulation film LIL3-Ia may be formed in the first to third barrier openings OP1-P, OP2-P, and OP3-P and the recesses HM. Specifically, the third lower inorganic encapsulation film LIL3-Ia may be formed in the recesses HM defined by the barrier wall PW adjacent to the third light-emitting opening OP3-E and may not be formed in the recesses HM defined by the barrier wall PW adjacent to the first light-emitting opening OP1-E. Furthermore, a portion of the third lower inorganic encapsulation film LIL3-Ia may fill the second space BS2 formed when the second lower inorganic encapsulation pattern LIL2a is etched.

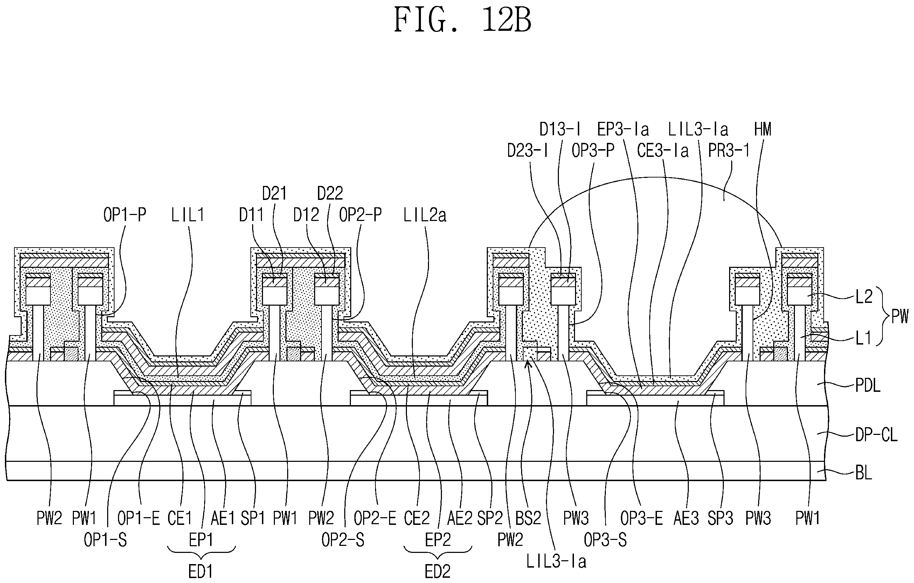

Referring to FIG. 12B, the third group process may include an operation of forming a third photoresist layer PR3-1. The third photoresist layer PR3-1 may be formed by forming a preliminary photoresist layer on the third lower inorganic encapsulation film LIL3-Ia and making the preliminary photoresist layer subject to patterning by a photo mask. Through the patterning process, the third photoresist layer PR3-1 may be formed in a pattern form corresponding to the third light-emitting opening OP3-E. Specifically, an edge of the third photoresist layer PR3-1 may be formed so as not to overlap the recesses HM adjacent to the third light-emitting opening OP3-E.

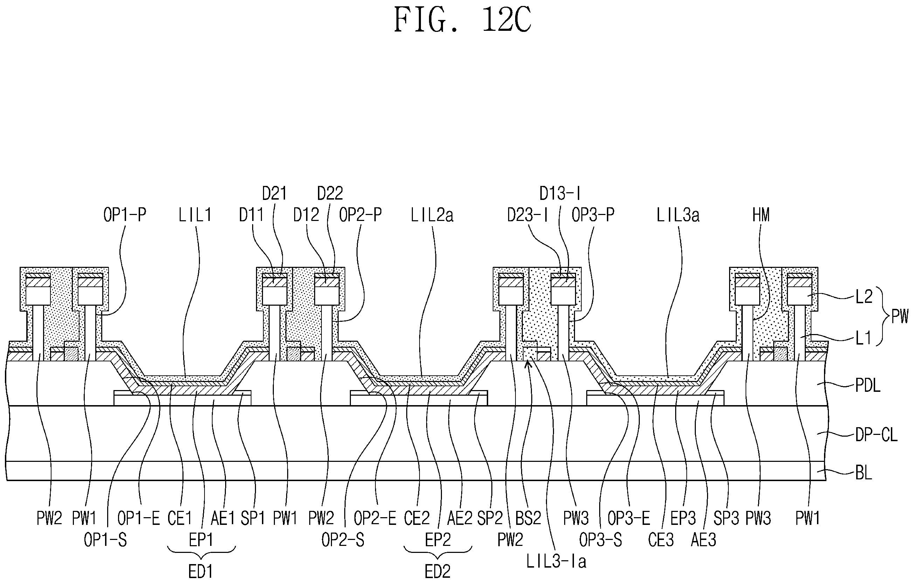

Referring to FIGS. 12B and 12C, the third group process may include an operation of forming the third emission pattern EP3, the third cathode CE3, and the third lower inorganic encapsulation pattern LIL3a through the sixth etching process.

The sixth etching process may dry etch the third preliminary emission pattern EP3-Ia, the third preliminary cathode CE3-Ia, and the third lower inorganic encapsulation film LIL3-Ia by the third photoresist layer PR3-1 as a mask. As a result of the dry etching, portions of the third preliminary emission pattern EP3-Ia, the third preliminary cathode CE3-Ia, and the third lower inorganic encapsulation film LIL3-Ia that overlap the first anode AE1 and the second anode AE2 may be removed. The third emission pattern EP3, the third cathode CE3, and the third lower inorganic encapsulation pattern LIL3a that overlap the third light-emitting opening OP3-E may be formed from the third preliminary emission pattern EP3-Ia, the third preliminary cathode CE3-Ia, and the third lower inorganic encapsulation film LIL3-Ia from which the portions overlapping the first anode AE1 and the second anode AE2 are removed.

One portion of the third lower inorganic encapsulation pattern LIL3a may be disposed in the third barrier opening OP3-P and may cover the third light-emitting element ED3, and another portion of the third lower inorganic encapsulation pattern LIL3a may be disposed in the recesses HM along the upper surface of the barrier wall PW. That is, at least a portion of the third lower inorganic encapsulation pattern LIL3a may be accommodated in the recesses HM. As a result of etching the third lower inorganic encapsulation film LIL3-Ia using the third photoresist layer PR3-1 as a mask, the third lower inorganic encapsulation film LIL3-Ia may be etched in regions overlapping the recesses HM such that the upper surface of the second lower inorganic encapsulation pattern LIL2a and the upper surface of the third lower inorganic encapsulation pattern LIL3a are aligned.

The first to third light-emitting elements ED1, ED2, and ED3 and the first to third lower inorganic encapsulation patterns LIL1, LIL2a, and LIL3a may be formed through the first to third group processes. The display panel DPa including the thin film encapsulation layer TFEa may be completed through the fourth group process after the third group process.

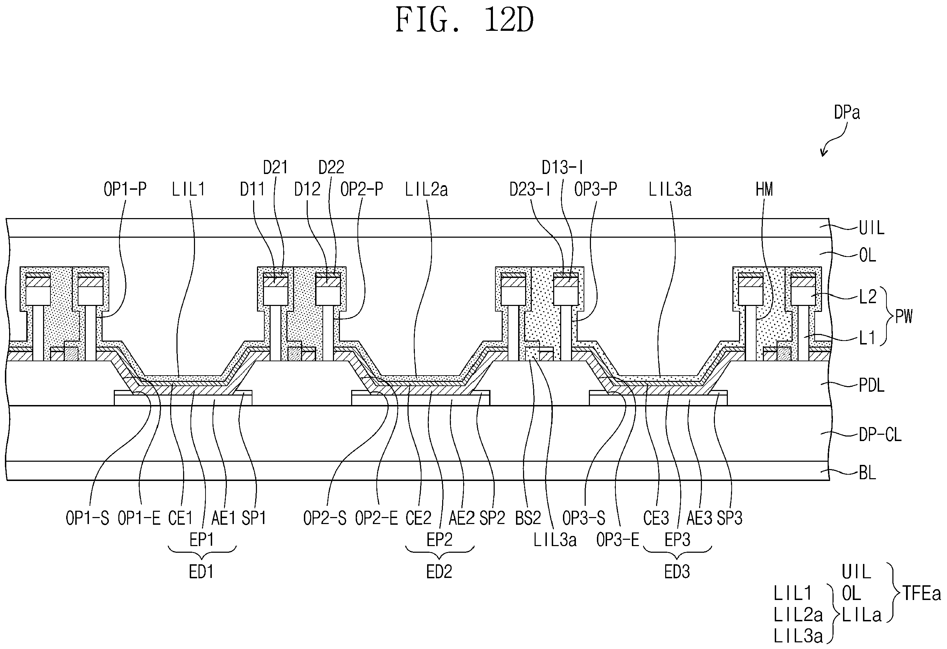

Referring to FIG. 12D, the fourth group process may include an operation of forming the organic encapsulation film OL on the first to third lower inorganic encapsulation patterns LIL1, LIL2a, and LIL3a and an operation of forming the upper inorganic encapsulation film UIL on the organic encapsulation film OL. The first to third lower inorganic encapsulation patterns LIL1, LIL2a, and LIL3a, the organic encapsulation film OL, and the upper inorganic encapsulation film UIL may be also referred to as the thin film encapsulation layer TFEa. Accordingly, the display panel DPa including the base layer BL, the circuit element layer DP-CL, the display element layer DP-OL, and the thin film encapsulation layer TFEa may be formed.

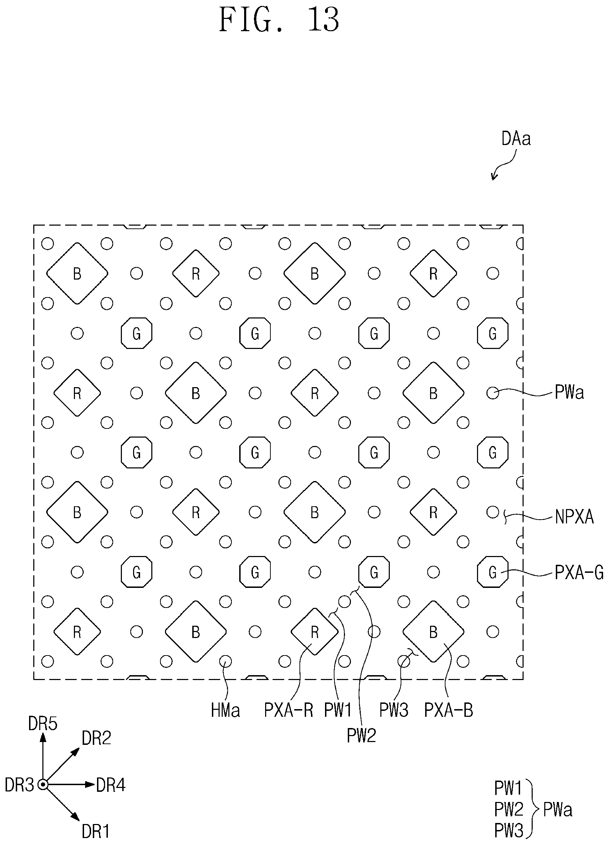

FIG. 13 is an enlarged plan view of an embodiment of a portion of a display region DAa according to the disclosure. In describing FIG. 13, the description will be made with reference to FIG. 5, and descriptions of the same reference numerals will be omitted.

Referring to FIGS. 5 and 13, a barrier wall PWa may include a first barrier wall portion PW1 defining a first barrier opening OP1-P, a second barrier wall portion PW2 defining a second barrier opening OP2-P, and a third barrier wall portion PW3 defining a third barrier opening OP3-P. A recess HMa may be defined between the first barrier wall portion PW1 and the second barrier wall portion PW2 and between the second barrier wall portion PW2 and the third barrier wall portion PW3.

The recess HMa of the barrier wall PWa may have a circular shape in a plan view. A plurality of recesses HMa may be provided. The recesses HMa may be arranged in the first direction DR1 or the second direction DR2. The recesses HMa may be arranged around the first barrier opening OP1-P (refer to FIG. 6), the second barrier openings OP2-P (refer to FIG. 6) and the third barrier opening OP3-P (refer to FIG. 6). That is, the recesses HMa may be arranged in a peripheral region NPXA between first to third emissive regions PXA-R, PXA-G, and PXA-B.

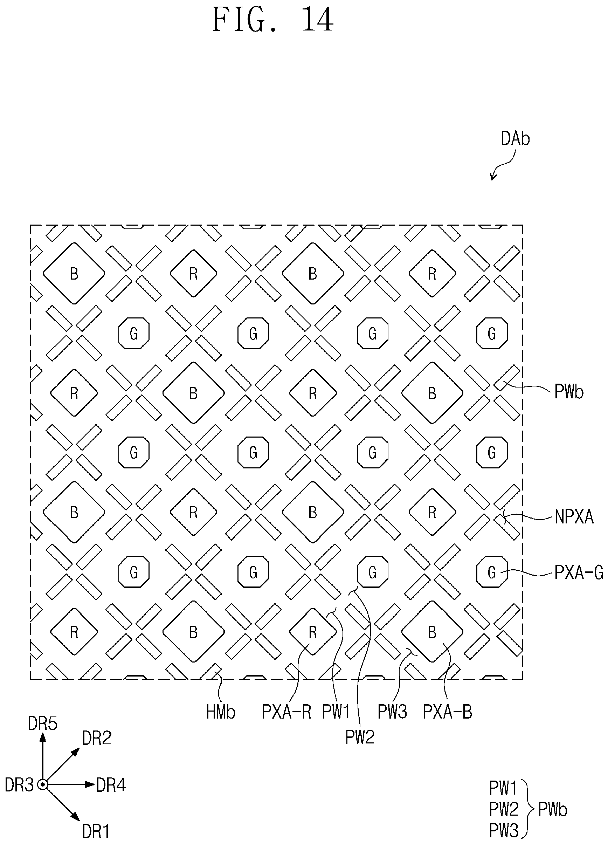

FIG. 14 is an enlarged plan view of an embodiment of a portion of a display region DAb according to the disclosure. In describing FIG. 14, the description will be made with reference to FIG. 5, and descriptions of the same reference numerals will be omitted.

Referring to FIGS. 5 and 14, a barrier wall PWb may include a first barrier wall portion PW1 defining a first barrier opening OP1-P, a second barrier wall portion PW2 defining a second barrier opening OP2-P, and a third barrier wall portion PW3 defining a third barrier opening OP3-P. A recess HMb may be defined between the first barrier wall portion PW1 and the second barrier wall portion PW2 and between the second barrier wall portion PW2 and the third barrier wall portion PW3.

The recess HMb of the barrier wall PWb may have a bar shape in a plan view. A plurality of recesses HMb may be provided. The recesses HMb may be arranged in the first direction DR1 or the second direction DR2. A plurality of recesses HMb may be defined between the first barrier wall portion PW1 and the second barrier wall portion PW2 and between the second barrier wall portion PW2 and the third barrier wall portion PW3.

Although FIGS. 5, 13, and 14 illustrate the recesses HM, HMa, and HMb having a circular shape or a bar shape, the shapes of the recesses HM, HMa, and HMb are not limited thereto. In addition, the arrangements of the recesses HM, HMa, and HMb and the numbers of recesses HM, HMa, and HMb are illustrative and are not limited to the embodiments illustrated in FIGS. 5, 13, and 14.

As described above, portions of the emission patterns (hereinafter, also referred to as the sacrificial emission patterns) may be separately formed in the recesses between the first to third barrier wall portions, and in the recesses, the lower encapsulation layer may be formed on the sacrificial emission patterns. Even though the sacrificial emission patterns are lost in an etching process, since the portions of the lower encapsulation layer disposed in the recesses of the barrier wall are fixed by the tip portions of the barrier wall, the shape of the thin film encapsulation layer may be maintained. Accordingly, oxidation of the cathodes may be prevented by blocking the moisture permeation path into the light-emitting elements, and thus the reliability of the display device may be improved.

The first barrier wall portion defining the first barrier opening, the second barrier wall portion defining the second barrier opening, the third barrier wall portion defining the third barrier opening, and the recesses may be simultaneously formed by the same process using one mask. Accordingly, the number of masks desired for forming the display panel may be decreased. In addition, the first to third light-emitting openings of the pixel defining layer may be simultaneously formed by the same process using one mask. Accordingly, the number of masks desired for forming the display panel may be decreased.

While the disclosure has been described with reference to embodiments thereof, it will be apparent to those of ordinary skill in the art that various changes and modifications may be made thereto without departing from the scope of the disclosure as set forth in the following claims.

## Claims

1. A display panel comprising:
a base layer;
a pixel defining layer disposed on the base layer, the pixel defining layer including a first light-emitting opening and a second light-emitting opening spaced apart from the first light-emitting opening in a first direction;
a barrier wall disposed on the pixel defining layer, the barrier wall including a first barrier wall portion which defines a first barrier opening which overlaps the first light-emitting opening and a second barrier wall portion which defines a second barrier opening which overlaps the second light-emitting opening;
a first light-emitting element disposed in the first barrier opening, the first light-emitting element including a first anode, a first emission pattern, and a first cathode which contacts the first barrier wall portion; and
a second light-emitting element disposed in the second barrier opening, the second light-emitting element including a second anode, a second emission pattern, and a second cathode which contacts the second barrier wall portion,
wherein a recess is defined in the barrier wall between the first barrier wall portion and the second barrier wall portion.

2. The display panel of claim 1, further comprising:
a lower encapsulation layer which covers the first light-emitting element and the second light-emitting element,
wherein the lower encapsulation layer includes:
a first lower inorganic encapsulation pattern which overlaps the first light-emitting opening and is disposed on the first light-emitting element and the first barrier wall portion; and
a second lower inorganic encapsulation pattern which overlaps the second light-emitting opening and is disposed on the second light-emitting element and the second barrier wall portion.

3. The display panel of claim 2, wherein a portion of the first lower inorganic encapsulation pattern and a portion of the second lower inorganic encapsulation pattern are accommodated in the recess.

4. The display panel of claim 2 or claim 3, wherein a space is defined between a portion of the first lower inorganic encapsulation pattern and the pixel defining layer in the recess, and a portion of the second lower inorganic encapsulation pattern is disposed in the space.

5. The display panel of any one of claims 2 to 4, wherein in the recess, a portion of the first lower inorganic encapsulation pattern and a portion of the second lower inorganic encapsulation pattern contact each other, and another portion of the first lower inorganic encapsulation pattern and another portion of the second lower inorganic encapsulation pattern are spaced apart from each other in the first direction.

6. The display panel of any one of claims 2 to 5, wherein a groove is defined in a thickness direction of the barrier wall in a region of the lower encapsulation layer which overlaps the recess, optionally wherein a portion of a side surface which defines the groove is defined by the first lower inorganic encapsulation pattern, and another portion of the side surface is defined by the second lower inorganic encapsulation pattern.

7. The display panel of any one of claims 2 to 4, wherein an upper surface of the lower encapsulation layer which overlaps the recess is flat.

8. The display panel of any one of claims 2 to 4 and 7, wherein an upper surface of the first lower inorganic encapsulation pattern and an upper surface of the second lower inorganic encapsulation pattern are aligned with each other in a region which overlaps the recess.

9. The display panel of any one of claims 1 to 8, wherein a portion of the second emission pattern and a portion of the second cathode are disposed in the recess.

10. The display panel of any one of claims 1 to 9, wherein:
(i) the recess, when viewed from above a plane, has a bar shape which extends in the first direction or a second direction crossing the first direction; or
(ii) the recess has a circular shape when viewed from above a plane.

11. The display panel of any one of claims 1 to 10, wherein:
(i) the recess includes a plurality of recesses arranged in the first direction or a second direction crossing the first direction; and/or
(ii) the recess includes a plurality of recesses arranged around the first barrier opening and the second barrier opening when viewed from above a plane.

12. A method for manufacturing a display panel, the method comprising:
providing a preliminary display panel including a base layer, a first anode disposed on the base layer, a second anode disposed on the base layer, a preliminary pixel defining layer which is disposed on the base layer and covers the first anode and the second anode, and a preliminary barrier wall;
forming a barrier wall by etching the preliminary barrier wall, the barrier wall including a first barrier opening which overlaps the first anode, a second barrier opening which overlaps the second anode, and a recess defined between the first barrier opening and the second barrier opening;
forming a pixel defining layer by etching the preliminary pixel defining layer, the pixel defining layer including a first light-emitting opening which exposes a portion of the first anode and a second light-emitting opening which exposes a portion of the second anode;
forming a first emission pattern and a first cathode in the first light-emitting opening;
forming a first lower inorganic encapsulation pattern which covers the first barrier opening and at least partially accommodated in the recess;
forming a second emission pattern and a second cathode in the second light-emitting opening; and
forming a second lower inorganic encapsulation pattern which covers the second barrier opening and at least partially accommodated in the recess.

13. The method of claim 12, wherein the forming the barrier wall including the first barrier opening, the second barrier opening, and the recess includes forming the recess between a first barrier wall portion which defines the first barrier opening and a second barrier wall portion which defines the second barrier opening when the recess is viewed from above a plane, and
wherein the first barrier opening, the second barrier opening, and the recess are simultaneously formed by the same process.

14. The method of claim 12 or claim 13, wherein:
(i) the forming the first emission pattern and the first cathode in the first light-emitting opening includes:
forming a first preliminary emission pattern on the pixel defining layer;
forming a first preliminary cathode on the first preliminary emission pattern;
forming a first photoresist layer on the first preliminary cathode, the first photoresist layer corresponding to the first light-emitting opening; and
forming the first emission pattern and the first cathode by etching the first preliminary emission pattern and the first preliminary cathode, and
wherein an edge of the first photoresist layer overlaps the recess; and/or
(ii) the forming the second lower inorganic encapsulation pattern includes forming a groove in a thickness direction of the barrier wall in regions of the first lower inorganic encapsulation pattern and the second lower inorganic encapsulation pattern which overlap the recess, and
wherein a portion of a side surface which defines the groove is defined by the first lower inorganic encapsulation pattern, and another portion of the side surface is defined by the second lower inorganic encapsulation pattern.

15. The method of claim 12 or claim 13, wherein the forming the first emission pattern and the first cathode in the first light-emitting opening includes:
forming a first preliminary emission pattern on the pixel defining layer;
forming a first preliminary cathode on the first preliminary emission pattern;
forming a first photoresist layer on the first preliminary cathode, the first photoresist layer corresponding to the first light-emitting opening; and
forming the first emission pattern and the first cathode by etching the first preliminary emission pattern and the first preliminary cathode, and
wherein an edge of the first photoresist layer does not overlap the recess.

16. The method of any one of claims 12, 13 and 15, wherein the forming the second lower inorganic encapsulation pattern includes etching the second lower inorganic encapsulation pattern such that an upper surface of the first lower inorganic encapsulation pattern and an upper surface of the second lower inorganic encapsulation pattern are aligned with each other in a region which overlaps the recess.

17. The method of any one of claims 12 to 16, wherein:
(i) the method further comprises:
forming an organic encapsulation film on the first lower inorganic encapsulation pattern and the second lower inorganic encapsulation pattern; and
forming an upper inorganic encapsulation film on the organic encapsulation film; and/or
(ii) the forming the second lower inorganic encapsulation pattern includes forming a space between a portion of the first lower inorganic encapsulation pattern and the pixel defining layer in the recess and filling the space with a portion of the second lower inorganic encapsulation pattern.
